# EUROPEAN PATENT APPLICATION

(11) **EP 2 482 327 A2**
(43) Date of publication of application: **01.08.2012**
(21) Application number: 12000546.7
(22) Date of filing: 27.01.2012
(51) Int. Cl.: H01L 31/0224

(54) **Solar cell and method for manufacturing the same**

(30) Priority: 28.01.2011 KR 20110008751
(71) Applicant: LG Electronics Inc., Yeongdeungpo-gu Seoul 150-721 (KR)
(72) Inventor: Shim, Seunghwan, Seoul 137-724 (KR); Kim, Jinah, Seoul 137-724 (KR); Nam, Jeongbeom, Seoul 137-724 (KR); Chung, Indo, Seoul 137-724 (KR); Yang, Juhong, Seoul 137-724 (KR); Jung, Ilhyoung, Seoul 137-724 (KR); Kwon, Hyungjin, Seoul 137-724 (KR)
(74) Representative: Katérle, Axel

(57) **Abstract**

A solar cell and a method for manufacturing the same are discussed. The solar cell includes a semiconductor substrate containing first impurities of a first conductive type, an anti-reflection layer which is positioned on the semiconductor substrate and has a fixed charge of the first conductive type, an ohmic contact region in which second impurities of a second conductive type different from the first conductive type of the first impurities of the semiconductor substrate are selectively positioned at the semiconductor substrate, a plurality of first electrodes which are positioned on the ohmic contact region and are connected to the ohmic contact region, and a second electrode connected to the semiconductor substrate.

## Description

### BACKGROUND OF THE INVENTION

### Field of the Invention

Embodiments of the invention relate to a solar cell and a method for manufacturing the same.

### Description of the Related Art

Recently, as existing energy sources such as petroleum and coal are expected to be depleted, interests in alternative energy sources for replacing the existing energy sources are increasing. Among the alternative energy sources, solar cells for generating electric energy from solar energy have been particularly spotlighted.

A solar cell generally includes semiconductor parts, which have different conductive types, for example, a p-type and an n-type and form a p-n junction, and electrodes respectively connected to the semiconductor parts of the different conductive types.

When light is incident on the solar cell, a plurality of electron-hole pairs are produced in the p-n junction of the semiconductor parts. The electron-hole pairs are separated into electrons and holes by the photoelectric effect. The separated electrons move to the n-type semiconductor part, and the separated holes move to the p-type semiconductor part. Then, the electrons are collected by the electrodes electrically connected to the n-type semiconductor part, and holes are collected by the electrodes electrically connected to the p-type semiconductor part. The electrodes are connected to each other using electric wires to thereby obtain electric power.

### SUMMARY OF THE INVENTION

In one aspect, there is a solar cell including a semiconductor substrate containing first impurities of a first conductive type, an anti-reflection layer positioned on the semiconductor substrate, the anti-reflection layer having a fixed charge of the first conductive type, an ohmic contact region in which second impurities of a second conductive type different from the first conductive type of the first impurities of the semiconductor substrate are selectively positioned at the semiconductor substrate, a plurality of first electrodes which are positioned on the ohmic contact region and are connected to the ohmic contact region, and a second electrode connected to the semiconductor substrate.

The solar cell may further include a semiconductor electrode positioned in a direction crossing or parallel to the plurality of first electrodes.

The plurality of first electrodes may be disposed in a lattice shape.

The anti-reflection layer may include a first layer positioned directly on the semiconductor substrate and a second layer positioned on the first layer. The first layer may have the fixed charge, and the second layer may not have the fixed charge.

The ohmic contact region may be further positioned on the anti-reflection layer

The anti-reflection layer may have a fixed charge density of about 2.0×10¹² /cm² to 4.0×10¹² /cm².

In another aspect, there is a method for manufacturing a solar cell including selectively forming an ohmic contact region at a first portion of a semiconductor substrate, forming an anti-reflection layer having a fixed charge density directly on a second portion of the semiconductor substrate, at which the ohmic contact region is not formed, and forming a plurality of first electrodes connected to the ohmic contact region and a second electrode connected to the semiconductor substrate.

The fixed charge density of the anti-reflection layer may be about 2.0×10¹² /cm² to 4.0×10¹² /cm².

When the semiconductor substrate may be of a p-type, the anti-reflection layer may have a positive fixed charge density, and when semiconductor substrate may be of an n-type, the anti-reflection layer may have a negative fixed charge density.

The forming of the ohmic contact region may include selectively forming an impurity film containing impurities of a second conductive type opposite a first conductive type at the first portion of the semiconductor substrate, and applying heat to the impurity film and doping the impurities of the second conductive type on the first portion of the semiconductor substrate to form the ohmic contact region.

The forming of the ohmic contact region may include forming an anti-diffusion layer on the first portion of the semiconductor substrate, removing a portion of the anti-diffusion layer to form an opening partially exposing the first portion of the semiconductor substrate in the anti-diffusion layer, injecting impurities of a second conductive type opposite a first conductive type into the first portion of the semiconductor substrate exposed through the opening to form the ohmic contact region, and removing the impurities remaining on the semiconductor substrate.

The forming of the anti-reflection layer, the plurality of first electrodes, and the second electrode may include forming an anti-reflection part on one surface of the semiconductor substrate, forming a first electrode pattern on the anti-reflection part, forming a second electrode pattern on the semiconductor substrate, and performing a thermal process on the semiconductor substrate having the first electrode pattern and the second electrode pattern, wherein the first electrode pattern may be positioned on the ohmic contact region, wherein the first electrode pattern may pass through the anti-reflection part and may be connected to the ohmic contact region to form the plurality of first electrodes connected to the ohmic contact region, and the second electrode pattern may form the second electrode connected to the semiconductor substrate through the thermal process of the semiconductor substrate, and wherein a portion of the anti-reflection part, through which the first electrode pattern does not pass, may form the anti-reflection layer.

The forming of the ohmic contact region and the anti-reflection layer may include forming an anti-reflection part on one surface of the semiconductor substrate, removing a portion of the anti-reflection part and forming an opening partially exposing the first portion of the semiconductor substrate in the anti-reflection part to form the anti-reflection layer, and injecting impurities of a second conductive type opposite a first conductive type into the first portion of the semiconductor substrate exposed through the opening to form the ohmic contact region.

The forming of the plurality of first electrodes and the second electrode may include forming a first electrode pattern directly on the ohmic contact region exposed through the opening, forming a second electrode pattern on the semiconductor substrate, and performing a thermal process on the semiconductor substrate having the first electrode pattern and the second electrode pattern, wherein the first electrode pattern may be connected to the ohmic contact region and the second electrode pattern may be connected to the semiconductor substrate through the thermal process of the semiconductor substrate.

The ohmic contact region may be formed of transparent conductive oxide.

The forming of the ohmic contact region and the anti-reflection layer may include forming an anti-reflection part on one surface of the semiconductor substrate, removing a portion of the anti-reflection part and forming an opening partially exposing the first portion of the semiconductor substrate in the anti-reflection part to form the anti-reflection layer, and forming the transparent conductive oxide on the first portion of the semiconductor substrate exposed through the opening and on the anti-reflection layer to form the ohmic contact region.

The transparent conductive oxide may be formed using a sputtering method.

The forming of the plurality of first electrodes and the second electrode may include forming a first electrode pattern on the ohmic contact region formed in the opening, forming a second electrode pattern on the semiconductor substrate, and performing a thermal process on the semiconductor substrate having the first electrode pattern and the second electrode pattern, wherein the first electrode pattern may be connected to the ohmic contact region and the second electrode pattern may be connected to the second portion of the semiconductor substrate through the thermal process of the semiconductor substrate.

### BRIEF DESCRIPTION OF THE DRAWINGS

The accompanying drawings, which are included to provide a further understanding of the invention and are incorporated in and constitute a part of this specification, illustrate embodiments of the invention and together with the description serve to explain the principles of the invention. In the drawings:

FIG. 1 is a partial perspective view of a solar cell according to an example embodiment of the invention;

FIG. 2 is a cross-sectional view taken along a line II-II of FIG. 1 according to an example embodiment of the invention;

FIG. 3 is a partial plane view schematically illustrating formation locations of a front electrode part and an ohmic contact region in a solar cell shown in FIGS. 1 and 2 according to an example embodiment of the invention;

FIG. 4 is a graph indicating changes in an impurity doping concentration of n-type impurities depending on changes in a depth of a p-type substrate when the n-type impurities are doped on the p-type substrate according to an example embodiment of the invention;

FIG. 5 is a graph indicating changes in a lifetime of carriers depending on changes in a depth of a p-type substrate when n-type impurities are doped on the p-type substrate according to an example embodiment of the invention;

FIG. 6 is a graph indicating changes in a short-circuit current and an open-circuit voltage depending on changes in a fixed charge density of an anti-reflection layer in a solar cell according to an example embodiment of the invention relative to a solar cell according to a comparative example;

FIG. 7 is a graph indicating changes in an external quantum efficiency (EQE) depending on changes in a wavelength of light in a solar cell according to an example embodiment of the invention relative to a solar cell according to a comparative example;

FIG. 8 is a graph indicating changes in an energy band generated by a contact between an anti-reflection layer and a substrate in a solar cell according to an example embodiment of the invention;

FIG. 9 is a graph indicating change percentages of electric power depending on changes in a fixed charge density of an anti-reflection layer in a solar cell according to an example embodiment of the invention relative to a solar cell according to a comparative example;

FIG. 10 is a graph indicating change percentages of electric power depending on changes in a fixed charge density of an anti-reflection layer and changes in a distance between front electrodes in a solar cell according to an example embodiment of the invention relative to a solar cell according to a comparative example;

FIGS. 11A to 11D sequentially illustrate an example of a method for manufacturing a solar cell according to an example embodiment of the invention;

FIGS. 12A and 12B illustrate another example of a method for forming an ohmic contact region according to an example embodiment of the invention;

FIGS. 13A to 13D sequentially illustrate another example of a method for manufacturing a solar cell according to an example embodiment of the invention;

FIGS. 14 and 16 are partial plane views schematically illustrating formation locations of a front electrode part and an ohmic contact region in various examples of a solar cell according to example embodiments of the invention;

FIGS. 15 and 17 are cross-sectional views taken along lines XV-XV and XVII-XVII of FIGS. 14 and 16, respectively;

FIGS. 18, 20 and 22 are partial plane views schematically illustrating formation locations of a front electrode part and an ohmic contact region in various examples of a solar cell according to example embodiments of the invention;

FIGS. 19, 21 and 23 are cross-sectional views taken along lines XIX-XIX, XXI-XXI and XXIII-XXIII of FIGS. 18, 20 and 22, respectively;

FIG. 24 is a partial perspective view of a solar cell according to another example embodiment of the invention;

FIG. 25 is a cross-sectional view taken along a line XXV-XXV of FIG. 24; and

FIGS. 26A to 26D sequentially illustrate an example of a method for manufacturing a solar cell shown in FIGS. 24 and 25.

### DETAILED DESCRIPTION OF THE EMBODIMENTS

Embodiments of the invention will be described more fully hereinafter with reference to the accompanying drawings, in which example embodiments of the invention are shown. This invention may, however, be embodied in many different forms and should not be construed as limited to the embodiments set forth herein.

In the drawings, the thickness of layers, films, panels, regions, etc., are exaggerated for clarity. Like reference numerals designate like elements throughout the specification. It will be understood that when an element such as a layer, film, region, or substrate is referred to as being "on" another element, it can be directly on the other element or intervening elements may also be present. In contrast, when an element is referred to as being "directly on" another element, there are no intervening elements present.

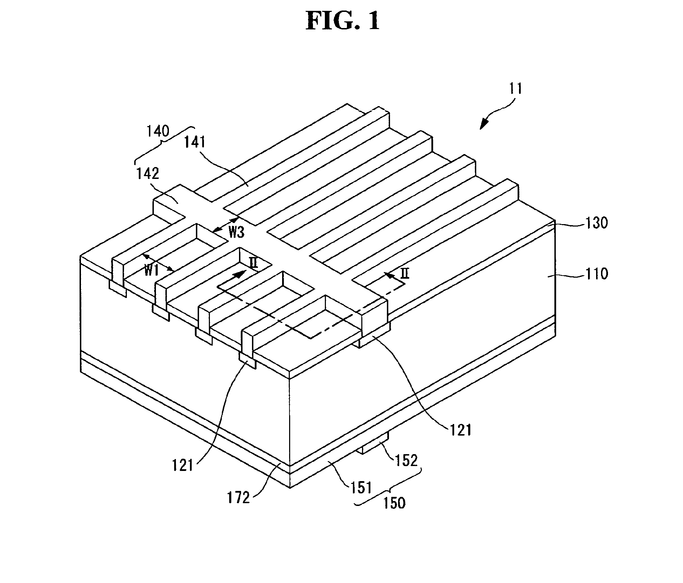

A solar cell according to an example embodiment of the invention is described below with reference to FIGS. 1 to 3.

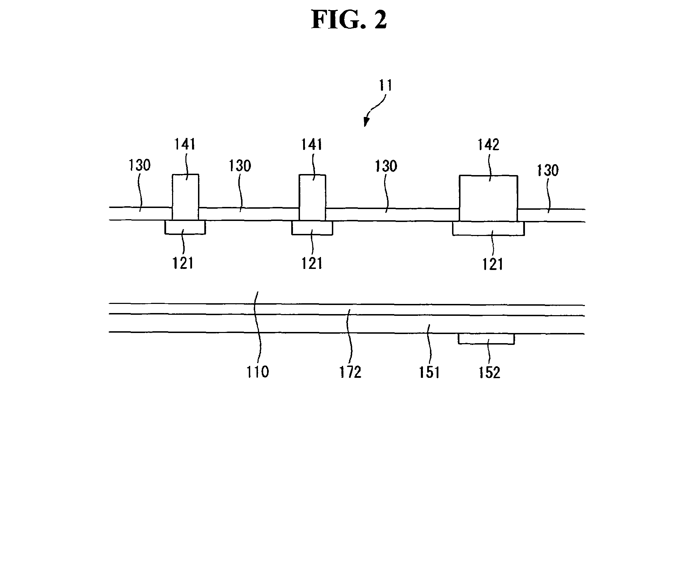

As shown in FIGS. 1 and 2, a solar cell 11 according to an embodiment of the invention includes a substrate 110, an ohmic contact region 121 partially (selectively or locally) positioned at a front surface (or referred to as "a first surface") of the substrate 110 on which light is incident, an anti-reflection layer 130 positioned on the substrate 110, a front electrode part 140 connected to the ohmic contact region 121, a back surface field (BSF) region (or referred to as "a surface field region") 172 positioned at a back surface (or referred to as "a second surface") opposite the front surface of the substrate 110, and a back electrode part 150 positioned on the back surface of the substrate 110.

The substrate 110 is a semiconductor substrate formed of a semiconductor such as first conductive type silicon, for example, p-type silicon, though not required. The semiconductor is a crystalline semiconductor such as single crystal silicon and polycrystalline silicon.

When the substrate 110 is of the p-type, the substrate 110 is doped with impurities of a group III element such as boron (B), gallium (Ga), and indium (In). Alternatively, the substrate 110 may be of an n-type. When the substrate 110 is of the n-type, the substrate 110 may be doped with impurities of a group V element such as phosphorus (P), arsenic (As), and antimony (Sb).

The front surface of the substrate 110 may be textured to form a textured surface corresponding to an uneven surface having a plurality of projections and a plurality of depressions or having uneven characteristics. In this instance, the anti-reflection layer 130 positioned on the front surface of the substrate 110 may have the textured surface.

When the front surface of the substrate 110 has the textured surface, a surface area of the substrate 110 may increase and an incident area of light may increase. Hence, an amount of light reflected from the substrate 110 may decrease, and an amount of light incident on the substrate 110 may increase.

When light is incident on the substrate 110, electrons and holes are generated by light energy based on the incident light.

The ohmic contact region 121 partially (or locally) positioned at the front surface of the substrate 110 is an impurity doped region doped with impurities of a second conductive type (for example, n-type) opposite the first conductive type (for example, p-type) of the substrate 110. The ohmic contact region 121 has an impurity doping concentration higher than the substrate 110.

The ohmic contact region 121 of the second conductive type forms a p-n junction along with a first conductive type region (for example, a p-type region) of the substrate 110.

The ohmic contact region 121 has a sheet resistance of about 5 Ω/sq. to 45 Ω/sq.

Unlike the above embodiment of the invention, the ohmic contact region 121 may be of the p-type when the substrate 110 is of the n-type in another example embodiment of the invention.

When the ohmic contact region 121 is of the n-type, the ohmic contact region 121 may be doped with impurities of a group V element. On the contrary, when the ohmic contact region 121 is of the p-type, the ohmic contact region 121 may be doped with impurities of a group III element.

The anti-reflection layer 130 positioned on the front surface of the substrate 110 is formed of a material capable of transmitting light and has a predetermined refractive index. The anti-reflection layer 130 reduces a reflectance of light incident on the solar cell 11 and increases selectivity of a predetermined wavelength band, thereby increasing the efficiency of the solar cell 11. In the example embodiment of the invention, the anti-reflection layer 130 may be transparent.

The anti-reflection layer 130 has a positive (+) or negative (-) fixed charge depending on the conductive type of the substrate 110.

For example, when the substrate 110 is of the p-type, the anti-reflection layer 130 has the positive fixed charge. When the substrate 110 is of the n-type, the anti-reflection layer 130 has the negative fixed charge.

When the anti-reflection layer 130 has the positive fixed charge, the anti-reflection layer 130 may be formed of hydrogenated silicon nitride (SiNx:H). When the anti-reflection layer 130 has the negative fixed charge, the anti-reflection layer 130 may be formed of aluminum oxide (Al₂O₃).

As above, because the anti-reflection layer 130 has the positive or negative fixed charge depending on the conductive type of the substrate 110, electrons and holes produced in the substrate 110 move to the corresponding components, respectively. Thus, the front electrode part 140 collects carriers moving to it, and the back electrode part 150 collects carriers moving to it.

When the substrate 110 is of the p-type, the anti-reflection layer 130 is formed of a material having the positive fixed charge, for example, silicon nitride (SiNx). Hence, because the anti-reflection layer 130 has the characteristic of the positive fixed charge, the anti-reflection layer 130 prevents a movement of holes corresponding to positive charges. As a result, the anti-reflection layer 130 prevents holes from moving to the front surface of the substrate 110, on which the anti-reflection layer 130 is positioned, and draws electrons corresponding to negative charges to the front surface of the substrate 110, i.e., to itself.

On the contrary, when the substrate 110 is of the n-type, the anti-reflection layer 130 is formed of a material having the negative fixed charge, for example, aluminum oxide (Al₂O₃). Hence, because the anti-reflection layer 130 has the characteristic of the negative fixed charge in this instance, the anti-reflection layer 130 prevents a movement of electrons corresponding to negative charges towards itself. As a result, the anti-reflection layer 130 prevents electrons from moving to the front surface of the substrate 110, on which the anti-reflection layer 130 is positioned, and draws holes corresponding to positive charges to the front surface of the substrate 110, i.e., to itself.

Moving paths of electrons and holes are determined by the anti-reflection layer 130, and thus, the electrons and the holes move along the determined moving paths, respectively. Hence, an amount of carriers (that is, the electrons and holes) lost by recombination and/or a disappearance of the electrons and the holes during the movement of the electrons and the holes decreases. Further, a moving speed of carriers increases because of the acceleration of corresponding carriers resulting from the anti-reflection layer 130, and thus, an amount of carriers moving to the front electrode part 140 increases.

Carriers (for example, electrons) moving from the substrate 110 to the anti-reflection layer 130 move to the ohmic contact region 121. Because the ohmic contact region 121 is more heavily doped than the substrate 110, the ohmic contact region 121 has a sheet resistance less than the substrate 110. Thus, the carriers moving to the anti-reflection layer 130 is collected in the ohmic contact region 121 having the relatively low sheet resistance.

For the above-described operation, the anti-reflection layer 130 has a fixed charge density of about 2.0×10¹² /cm² to 4.0×10¹² /cm².

The anti-reflection layer 130 may have a thickness of about 70 nm to 80 nm and, as an example, a refractive index of about 2.0 to 2.1.

When the refractive index of the anti-reflection layer 130 is equal to or greater than about 2.0, the reflectance of light decreases and an amount of light absorbed in the anti-reflection layer 130 further decreases. Further, when the refractive index of the anti-reflection layer 130 is equal to or less than about 2.1, the reflectance of light further decreases.

Further, in the embodiment of the invention, the anti-reflection layer 130 has the refractive index of about 2.0 to 2.1 between a refractive index (about 1) of air and a refractive index (about 3.5) of the substrate 110. Thus, because a refractive index in going from air to the substrate 110 gradually increases, the reflectance of light further decreases by the gradual increase in the refractive index. As a result, an amount of light incident on the substrate 110 further increases.

When the thickness of the anti-reflection layer 130 is equal to or greater than about 70 nm, an anti-reflection effect of light is more efficiently obtained. When the thickness of the anti-reflection layer 130 is equal to or less than about 80 nm, an amount of light absorbed in the anti-reflection layer 130 decreases and an amount of light incident on the substrate 110 increases. Further, in the process for manufacturing the solar cell 11, the front electrode part 140 stably and easily passes through the anti-reflection layer 130 and is stably connected to the ohmic contact region 121.

The anti-reflection layer 130 performs a passivation function which converts a defect, for example, dangling bonds existing at and around the surface of the substrate 110 into stable bonds using hydrogen (H) or oxygen (O) contained in the anti-reflection layer 130 to thereby prevent or reduce a recombination and/or a disappearance of carriers moving to the surface of the substrate 110. Hence, the anti-reflection layer 130 reduces an amount of carriers lost by the defect at the surface of the substrate 110.

The anti-reflection layer 130 shown in FIGS. 1 and 2 has a single-layered structure, but may have a multi-layered structure, for example, a double-layered structure in other example embodiments. The anti-reflection layer 130 may be formed of at least one of silicon nitride (SiNx), silicon oxide (SiOx), silicon oxynitride (SiOxNy), aluminum oxide (AlxOy), and titanium oxide (TiOx).

When the anti-reflection layer 130 has the multi-layered structure unlike the structure shown in FIGS. 1 and 2, a lowermost layer contacting the substrate 110 in a plurality of layers constituting the anti-reflection layer 130 has to have positive or negative fixed charge depending on the conductive type of the substrate 110 as described above. In this instance, the lowermost layer (or referred to as " a first layer") of the anti-reflection layer 130 may have a fixed charge density of about 2.0×10¹² /cm² to 4.0×10¹² /cm². Other layers (or referred to as "second layers") positioned on the lowermost layer may be formed of a material capable of improving an anti-reflection effect of light or compensating for a carrier separation moving operation resulting from the fixed charge density of the lowermost layer and/or may have a refractive index. Thereby, the second layers may not have the fixed charge.

The front electrode part 140 contacts the ohmic contact region 121 and includes a plurality of front electrodes (or a plurality of first electrodes) 141 and a plurality of front bus bars (or a plurality of first bus bars) 142 connected to the plurality of front electrodes 141.

The front electrode part 140 contains at least one conductive material, for example, silver (Ag).

The plurality of front electrodes 141 are referred to as a plurality of finger electrodes. The plurality of front electrodes 141 are spaced apart from one another with a distance between them and extend parallel to one another in a fixed direction. The plurality of front bus bars 142 extend parallel to one another in a direction crossing the front electrodes 141. Thus, each front bus bar 142 meets at crossings of the front electrodes 141 and each front bus bar 142.

Because the front electrodes 141 and the front bus bars 142 contact the ohmic contact region 121, the front electrodes 141 and the front bus bars 142 collect carriers (for example, electrons) moving to the ohmic contact region 121.

As described above, because the front electrodes 141 and the front bus bars 142 contain a metal material, the front electrodes 141 and the front bus bars 142 have a sheet resistance less than the ohmic contact region 121. Therefore, carriers moving from the substrate 110 to the ohmic contact region 121 move to the front electrodes 141 and the front bus bars 142 each having the sheet resistance less than the ohmic contact region 121. Then, the carriers move in the extension directions of the front electrodes 141 and the front bus bars 142.

The conductivity of the ohmic contact region 121 increases due to the impurity doping concentration of the ohmic contact region 121. The ohmic contact region 121 forms an ohmic contact between the substrate 110 and the front electrode part 140, thereby reducing a contact resistance between the front electrode part 140 and the ohmic contact region 121. Thus, an amount of carriers moving from the ohmic contact region 121 to the front electrode part 140 increases.

In other words, the ohmic contact region 121 makes carriers moving to the anti-reflection layer 130 move to the front electrode part 140 without a loss of the carriers. Therefore, the ohmic contact region 121 is positioned at the substrate 110 contacting the front electrode part 140.

As described above, the ohmic contact region 121 has the sheet resistance of about 5 Ω/sq. to 45 Ω/sq. When the sheet resistance of the ohmic contact region 121 is equal to or greater than about 5 Ω/sq., the ohmic contact region 121 stably forms an ohmic contact between the substrate 110 and the front electrode part 140 without increasing a process time or a thermal processing temperature for forming the ohmic contact region 121. When the sheet resistance of the ohmic contact region 121 is equal to or less than about 45 Ω/sq., the ohmic contact region 121 forms the ohmic contact for stably performing the movement of carriers from the substrate 110 to the front electrode part 140.

As above, carriers move from the ohmic contact region 121 to the corresponding front electrode 141 contacting the ohmic contact region 121 along the corresponding front electrode 141 and then move along the front bus bar 142 crossing the corresponding front electrode 141. After all, the plurality of front bus bars 142 collect carriers moving along the plurality of front electrodes 141 and move the carriers in a desired direction.

Because each front bus bar 142 has to collect carriers collected by the front electrodes 141 crossing the front bus bar 142 and has to transfer the collected carriers in a desired direction, a width of each front bus bar 142 is much greater than a width of each front electrode 141.

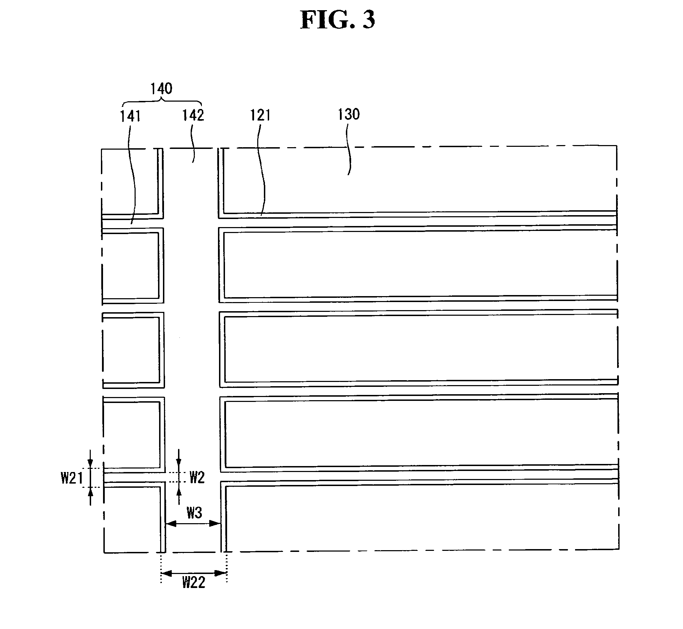

As shown in FIG. 1, the plurality of front electrodes 141 are disposed in a stripe shape extending in a transverse or longitudinal direction, and the plurality of front bus bars 142 are disposed in a stripe shape extending in a longitudinal or transverse direction. Thus, as shown in FIG. 3, the front electrode part 140 has a lattice shape on the front surface of the substrate 110.

As shown in FIG. 3, because the ohmic contact region 121 is positioned along the front electrode part 140 under the front electrode part 140, the ohmic contact region 121 is disposed in a lattice shape in the same manner as the front electrode part 140. The ohmic contact region 121 includes a first portion positioned under the front electrodes 141 and a second portion positioned under the front bus bars 142.

As shown in FIG. 3, a width W21 of the first portion of the ohmic contact region 121 positioned under the front electrodes 141 is greater than a width W2 of each front electrode 141, and a width W22 of the second portion of the ohmic contact region 121 positioned under the front bus bars 142 is greater than a width W3 of each front bus bar 142. Hence, a design margin of the front electrode part 140 positioned on the ohmic contact region 121 increases.

In the embodiment of the invention, as shown in FIGS. 1 and 3, a distance W1 between the two adjacent front electrodes 141 may be about 0.25 cm to 0.4 cm, and the width W2 of each front electrode 141 may be about 80 µm to 120 µm.

The plurality of front bus bars 142 are connected to an external device and output the collected carriers (for example, electrons) to the external device.

In the embodiment of the invention, the number of front electrodes 141 and the number of front bus bars 142 may vary, if necessary.

The BSF region 172 is a region (for example, a p⁺-type region) that is more heavily doped than the substrate 110 with impurities of the same conductive type as the substrate 110.

A potential barrier is formed by a difference between impurity doping concentrations of the first conductive type region of the substrate 110 and the BSF region 172, thereby reducing or preventing electrons from moving to the BSF region 172 used as a moving path of holes and making it easier for the holes to move to the BSF region 172. Thus, the BSF region 172 reduces an amount of carriers lost by a recombination and/or a disappearance of the electrons and the holes at and around the back surface of the substrate 110 and accelerates a movement of desired carriers (for example, holes), thereby increasing the movement of carriers to the back electrode part 150.

The back electrode part 150 includes a back electrode (or a second electrode) 151 and a plurality of back bus bars (or a plurality of second bus bars) 152 connected to the back electrode 151.

The back electrode 151 contacts the BSF region 172 positioned at the back surface of the substrate 110 and is substantially positioned on the entire back surface of the substrate 110. In an alternative example, the back electrode 151 may be not positioned at an edge of the back surface of the substrate 110.

The back electrode 151 contains a conductive material, for example, aluminum (Al).

The back electrode 151 collects carriers (for example, holes) moving to the BSF region 172.

Because the back electrode 151 contacts the BSF region 172 having the impurity doping concentration higher than the substrate 110, a contact resistance between the substrate 110 (i.e., the BSF region 172) and the back electrode 151 decreases. Hence, the transfer efficiency of carriers from the substrate 110 to the back electrode 151 is improved.

The plurality of back bus bars 152 are positioned on the back electrode 151 to be opposite to the plurality of front bus bars 142. Hence, the plurality of back bus bars 152 are connected to the back electrode 151. In embodiments of the invention, the front bus bars 142 are aligned with the back bus bars 152.

The plurality of back bus bars 152 collect carriers transferred from the back electrode 151 in the same manner as the plurality of front bus bars 142.

The plurality of back bus bars 152 are connected to the external device and output carriers (for example, holes) collected by the back bus bars 152 to the external device.

The plurality of back bus bars 152 may be formed of a material having better conductivity than the back electrode 151. The plurality of back bus bars 152 contain at least one conductive material, for example, silver (Ag).

An operation of the solar cell 11 having the above-described structure is described below.

When light irradiated to the solar cell 11 is incident on the substrate 110, which is the semiconductor part, through the anti-refection layer 130, a plurality of electron-hole pairs are generated in the substrate 110 by light energy based on the incident light. In this instance, because a reflection loss of the light incident on the substrate 110 is reduced by the anti-reflection layer 130, an amount of light incident on the substrate 110 increases.

The electron-hole pairs are separated into electrons and holes under the influence of the fixed charges of the anti-reflection layer 130. Then, the separated electrons move to the anti-reflection layer 130, and the separated holes move to the p-type semiconductor part, for example, the substrate 110. The electrons moving to the anti-reflection layer 130 are collected by the front electrodes 141 and the front bus bars 142 through the ohmic contact region 121 and then move along the front bus bars 142. The holes moving to the substrate 110 are collected by the back electrode 151 and then move along the back bus bars 152. When the front bus bars 142 are connected to the back bus bars 152 using electric wires, current flows therein to thereby enable use of the current for electric power.

Unlike a comparative example in which an ohmic contact region forming a p-n junction is formed at the entire front surface of a substrate on which light is incident, in the solar cell 11 according to the embodiment of the invention, the ohmic contact region 121 is formed only at a portion of the substrate 110 contacting the front electrode part 140 so as to efficiently perform the movement of carriers to the front electrode part 140. As the ohmic contact region 121 partially (selectively or locally) positioned at the front surface of the substrate 110 on portions where the anti-reflection layer 130 is not positioned, there is direct contact of the anti-reflection layer 130 to the substrate 110. Accordingly, the anti-reflection layer 130 is positioned where the ohmic contact region 121 is not formed. However, such is not required, and an intervening layer may be present between the anti-reflection layer 130 and the substrate 110 in other embodiments.

Hence, the efficiency of the solar cell 11 according to the embodiment of the invention is further improved, compared to the comparative example.

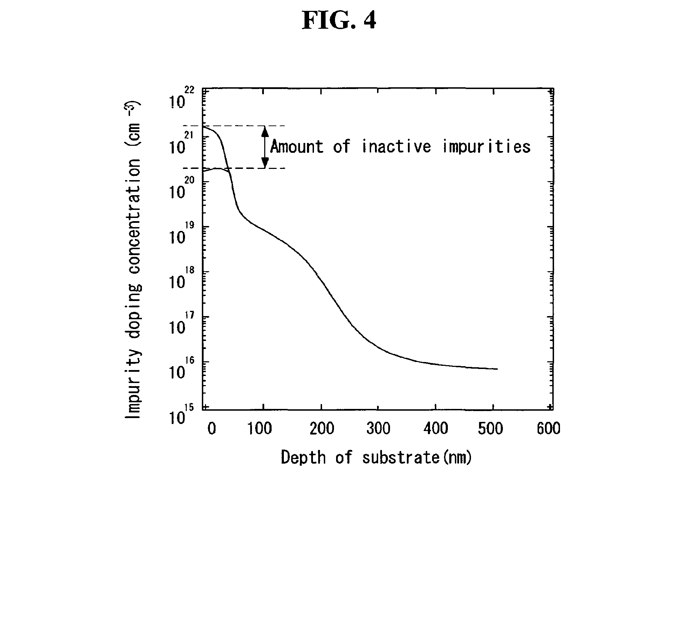

As shown in FIG. 4, when p-type or n-type impurities are doped on the semiconductor substrate to form the ohmic contact region 121, a doping concentration of the p-type or n-type impurities for the ohmic contact region 121 decreases as a depth of the substrate measured from the front surface of the substrate 110 increases. In this instance, the impurity doping concentration sharply decreases around a predetermined depth of the substrate 110.

In general, because impurities are diffused from the surface of the substrate to the inside of the substrate, a doping concentration of the impurities increases as it is close to the surface of the substrate. Thus, because the impurities equal to or greater than the solid solubility are injected around the surface of the substrate, the impurities diffused into the inside of the substrate increase a concentration of inactive impurities which are not normally combined with (are normally insoluble in) the material (i.e., silicon) of the substrate. The inactive impurities form a dead layer.

For example, when POCl₃ gas is diffused into the p-type silicon substrate to form the n-type ohmic contact region, clusters including phosphorus (P) elements corresponding to impurities and/or phosphorus (P) elements not combined with the silicon (Si) are formed inside the p-type silicon substrate. Because the clusters and the phosphorus (P) elements are not normally combined with silicon (Si), the clusters and the phosphorus (P) elements serve as the inactive impurities.

As the doping concentration of the impurities increases, the concentration of the inactive impurities increases. Therefore, as shown in FIG. 4, the concentration of the inactive impurities increases in going towards the surface of the substrate 110.

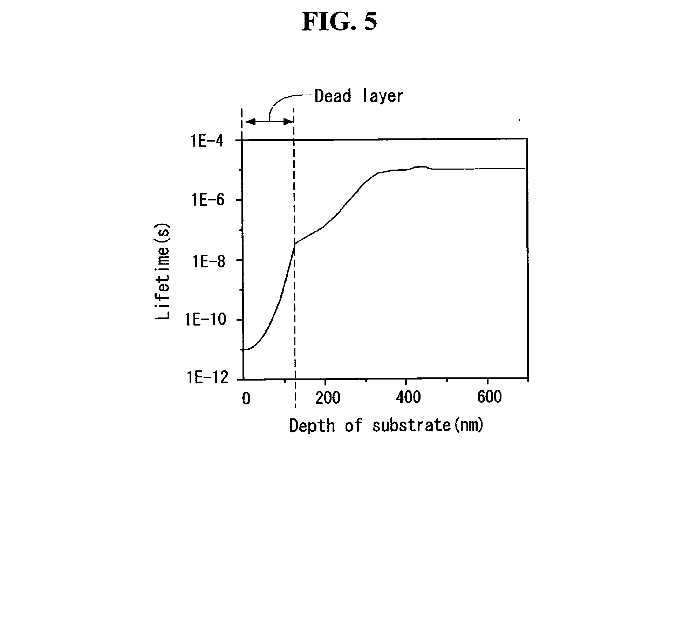

The inactive impurities exist at and/or around the surface of the substrate and are combined with carriers moving to the surface of the substrate, thereby causing disappearance of the carriers moving to the surface of the substrate and hindering the movement of minority carriers (for example, electrons in case of the p-type substrate). Hence, as shown in FIG. 5, the inactive impurities reduce a lifetime of carriers. Further, when the ohmic contact region 121 is positioned at the incident surface (that is, the front surface) of the substrate 110 on which light is incident, the ohmic contact region 121 absorbs light of a short wavelength band in the light incident on the substrate 110, thereby reducing an amount of light incident on the substrate 110. Hence, an amount of carriers produced in the substrate 110 decreases.

Accordingly, in the embodiment of the invention, the ohmic contact region 121 is formed only at a portion of the substrate 110 contacting the front electrode part 140 instead of the entire front surface of the substrate 110. Therefore, a reduction in an amount of carriers moving to the front electrode part 140 resulting from a loss of carriers due to the ohmic contact region 121 (i.e., the dead layer of the ohmic contact region 121) or a reduction in the lifetime of carriers is prevented. Hence, an amount of carriers produced in the substrate 110 increases.

However, when the ohmic contact region 121 is formed only at a portion of the substrate 110 contacting the front electrode part 140 so as to form the ohmic contact between the substrate 110 and the front electrode part 140 as in the embodiment of the invention, a formation area of the ohmic contact region 121, which forms the p-n junction along with the first conductive type region of the substrate 110, greatly decreases. Hence, a formation area of the p-n junction greatly decreases.

As a result, a directional movement (in which electrons move to the n-type component and the holes move to the p-type component) of electrons and holes produced in the substrate 110 that occurs by a drift current resulting from fixed charges of a depletion region generated in the p-n junction may be not stably performed. However, in the embodiment of the invention, since the function of the drift current is compensated by the fixed charge of the anti-reflection layer 130, the separation and the movement of carriers are stably performed using the fixed charge of the anti-reflection layer 130.

Accordingly, the example of the embodiment solves or addresses a loss of carriers and a reduction in the lifetime of carriers resulting from the recombination of carriers generated in the ohmic contact region 121 by reducing the formation area of the ohmic contact region 121 and normally performing the separation and the movement of electrons and holes produced in the substrate 110. Therefore, the efficiency of the solar cell 11 according to the embodiment of the invention is improved.

As above, the anti-reflection layer 130 according to the embodiment of the invention has to certainly move the corresponding carriers to the anti-reflection layer 130 (that is, the front electrode part 140) so as to stably perform the separation and the movement of electrons and holes produced in the substrate 110. Therefore, the anti-reflection layer 130 has to have the fixed charge density equal to or greater than a predetermined value. For example, the anti-reflection layer 130 may have the fixed charge density equal to or greater than about 2.0×10¹² /cm².

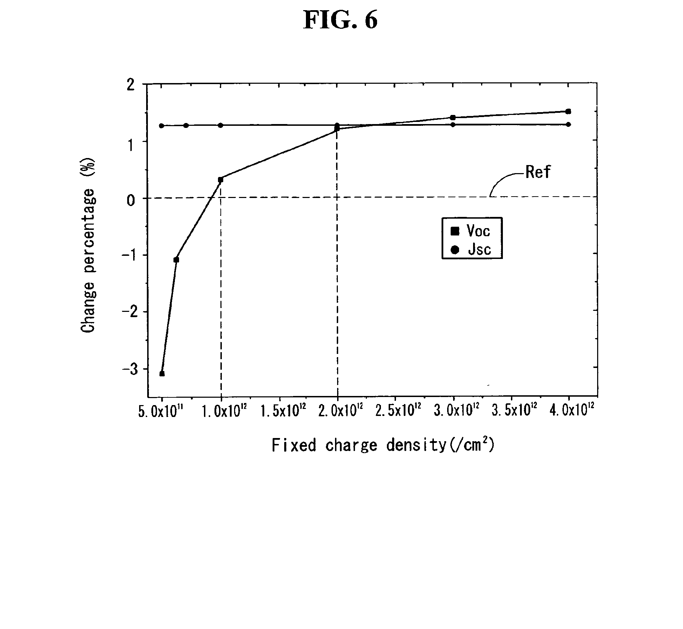

Operational characteristics of a solar cell according to a comparative example and the solar cell according to the embodiment of the invention are described below with reference to FIGS. 6 to 10.

In FIGS. 6 to 10, the graph `Ref' (i.e., the horizontal broken line designated as `Ref') indicates a solar cell according to the comparative example, and remaining graphs (i.e., the other lines) indicate the solar cell according to the embodiment of the invention.

The solar cell according to the comparative example is substantially the same as the solar cell according to the embodiment of the invention except the formation area of the ohmic contact region forming the p-n junction along with the substrate. In the solar cell according to the embodiment of the invention, the ohmic contact region is positioned only at a portion of the substrate contacting the front electrode part. On the other hand, in the solar cell according to the comparative example, the ohmic contact region exists under the front electrode part and even at the front surface of the substrate on which the front electrode part is not formed.

FIG. 6 illustrates changes in a short-circuit current Jsc and an open-circuit voltage Voc depending on changes in the fixed charge density of the anti-reflection layer 130 in the solar cell 11 according to the embodiment of the invention relative to on the solar cell according to the comparative example.

As shown in FIG. 6, the short-circuit current Jsc in the solar cell 11 according to the embodiment of the invention was kept at an almost constant level irrespective of the fixed charge density of the anti-reflection layer 130 and increased compared to the solar cell Ref according to the comparative example.

In other words, in the solar cell 11 according to the embodiment of the invention, the ohmic contact region 121 is positioned only under the front electrode part 140, which contains the metal material and blocks light from being incident on the substrate 110, and is not positioned at a portion of the substrate 110 on which light is incident, i.e., a portion of the substrate 110 on which the front electrode part 140 is not formed. Therefore, the absorption of light does not occur in the ohmic contact region 121.

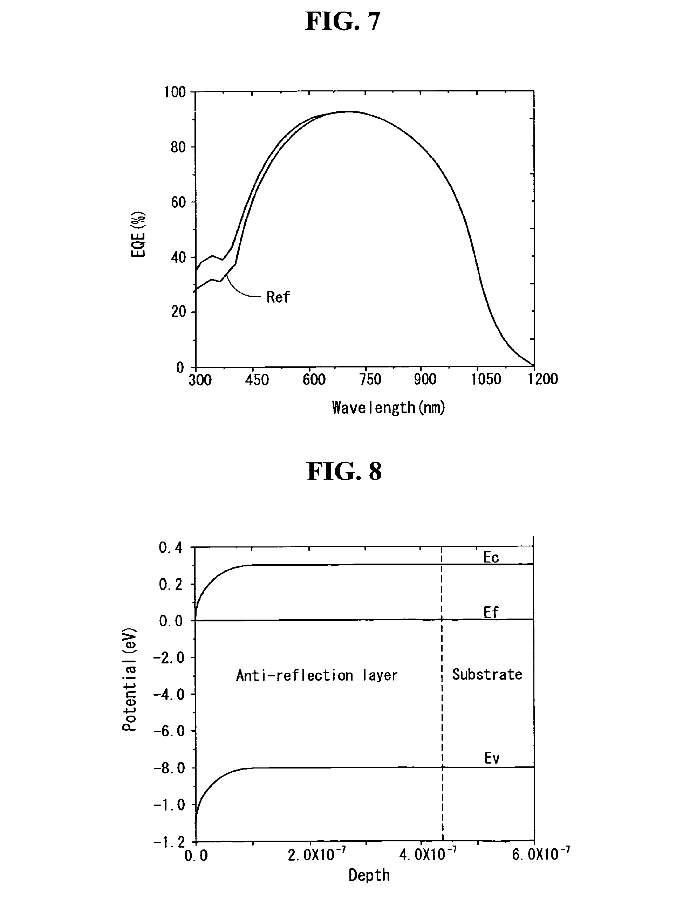

As a result, in the solar cell 11 according to the embodiment of the invention, an amount of light absorbed in the substrate 110 greatly increases, compared to the solar cell according to the comparative example in which the ohmic contact region is positioned at the portion of the substrate on which the front electrode part is not formed. Hence, in the solar cell 11 according to the embodiment of the invention, an amount of electrons and holes produced in the substrate 110 greatly increases, compared to the solar cell according to the comparative example. Namely, as shown in FIG. 7, an external quantum efficiency (EQE) in the solar cell 11 according to the embodiment of the invention was improved in a short wavelength band of about 300 nm to 350 nm of light, compared to the solar cell Ref according to the comparative example. Thus, because the ohmic contact region 121 was not positioned at the incident surface of the substrate 110 in the solar cell 11 according to the embodiment of the invention, an amount of light, more particularly light of the short wavelength band incident on the substrate 110, increased compared to the solar cell Ref according to the comparative example.

Accordingly, an amount of electrons and holes produced in the substrate 110 increases due to an increase in the amount of light incident on the substrate 110. Further, an amount of carriers flowing to the front electrode part 140 and the back electrode part 150 increases, and the short-circuit current Jsc increases.

As shown in FIG. 6, when the fixed charge density of the anti-reflection layer 130 was less than about 1.0×10¹² /cm², the open-circuit voltage Voc of the solar cell 11 according to the embodiment of the invention decreased compared to the solar cell Ref according to the comparative example. However, when the fixed charge density of the anti-reflection layer 130 was equal to or greater than about 1.0×10¹² /cm², the open-circuit voltage Voc of the solar cell 11 according to the embodiment of the invention increased compared to the solar cell Ref according to the comparative example.

The open-circuit voltage Voc increases due to an increase in an amount of light incident on the substrate 110.

As shown in FIG. 8, in going from a contact surface between the substrate 110 and the anti-reflection layer 130 to the surface of the anti-reflection layer 130, a bending phenomenon of an energy band in the anti-reflection layer 130 is generated due to the fixed charge of the anti-reflection layer 130. Hence, the open-circuit voltage Voc increases by the bending phenomenon of the energy band. As a result, the p-n junction effect of the ohmic contact region 121 can be obtained using the fixed charge of the anti-reflection layer 130. In FIG. 8, 'Ef' indicates a Fermi level, 'Ec' indicates a conduction band, and 'Ev' indicates a valance band.

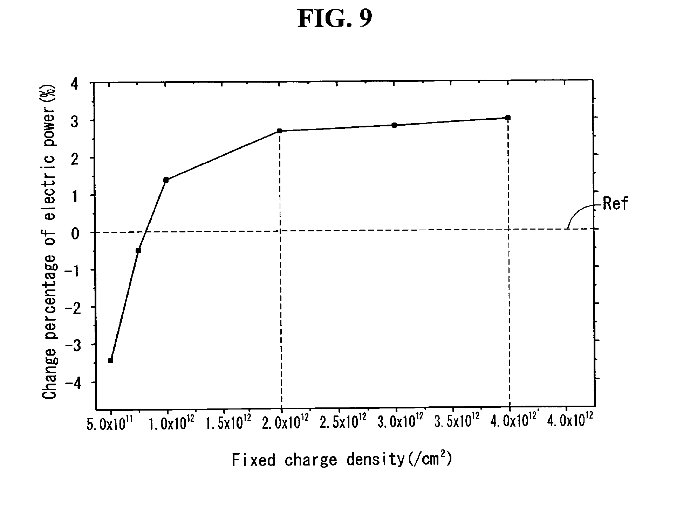

FIG. 9 illustrates change (increase and decrease) percentages of electric power of the solar cell 11 according to the embodiment of the invention relative to the solar cell Ref according to the comparative example.

As shown in FIG. 9, when the fixed charge density of the anti-reflection layer 130 was equal to or greater than about 1.0×10¹² /cm², the electric power of the solar cell 11 according to the embodiment of the invention was greater than the solar cell Ref according to the comparative example. In this instance, until the fixed charge density of the anti-reflection layer 130 was equal to about 2.0×10¹² /cm², an increase percentage of the electric power of the solar cell 11 sharply increased. Then, as the fixed charge density of the anti-reflection layer 130 was greater than about 2.0×10¹² /cm², the increase percentage of the electric power of the solar cell 11 slightly increased and was kept at an almost constant value.

Accordingly, the anti-reflection layer 130 may have the fixed charge density of about 2.0×10¹² /cm² to 4.0×10¹² /cm², so as to stably increase the electric power of the solar cell 11.

As can be seen from FIGS. 6 to 9, when the fixed charge density of the anti-reflection layer 130 is equal to or greater than about 2.0×10¹² /cm², the short-circuit current Jsc, the open-circuit voltage Voc, and the electric power of the solar cell 11 stably increase. Hence, the efficiency of the solar cell 11 is stably improved. Further, when the fixed charge density of the anti-reflection layer 130 is equal to or less than about 4.0×10¹² /cm², the fixed charge density of the anti-reflection layer 130 is easier controlled.

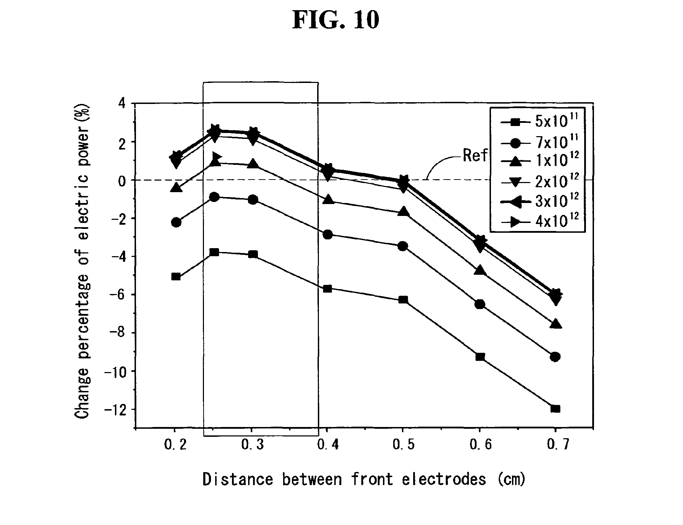

FIG. 10 illustrates change percentage in the electric power depending on changes in the fixed charge density of the anti-reflection layer 130 and changes in a distance between the front electrodes 141 in the solar cell 11 according to the embodiment of the invention relative to the solar cell Ref according to the comparative example.

As shown in FIG. 10, as the fixed charge density of the anti-reflection layer 130 decreased, the electric power of the solar cell 11 decreased compared to the solar cell Ref according to the comparative example. The change percentage in the in the electric power for different fixed charge densities are shown by respective lines connected by respective shapes. For example, the change percentage in the in the electric power for the fixed charge density of 5.0×10¹¹ /cm² is shown by the lines connected by the squares.

Further, as the distance between the front electrodes 141 increased, the electric power of the solar cell 11 decreased compared to the solar cell Ref according to the comparative example. As above, as the distance between the front electrodes 141 increases, a moving distance of carriers moving from the substrate 110 having the sheet resistance greater than the ohmic contact region 121 to the front electrodes 141 increases. Therefore, the electric power of the solar cell 11 decreases.

However, as shown in FIG. 10, even when the distance between the front electrodes 141 was equal to or less than a predetermined value, the electric power of the solar cell 11 decreased. As above, when the distance between the front electrodes 141 is equal to or less than the predetermined value, the number of front electrodes 141 positioned on the front surface of the substrate 110 increases. Hence, the formation area of the front electrodes 141 hindering light from being incident on the entire front surface of the substrate 110 increases. Namely, the incident area of light decreases. Accordingly, as shown in FIG. 10, if the distance between the front electrodes 141 excessively decreases so as to reduce the moving distance of carriers moving from the substrate 110 to the front electrodes 141, an amount of light incident on the substrate 110 may decrease. As a result, the electric power of the solar cell 11 decreases.

As shown in FIG. 10, when the fixed charge density of the anti-reflection layer 130 was about 2.0×10¹² /cm² to 4.0×10¹² /cm² and the distance between the two adjacent front electrodes 141 was about 0.25 cm to 0.4 cm, the electric power of the solar cell 11 increased compared to the solar cell Ref according to the comparative example. Further, the electric power of the solar cell 11was stably kept or maintained. Accordingly, in the solar cell 11 according to the embodiment of the invention, the distance between the two adjacent front electrodes 141 may be about 0.25 cm to 0.4 cm when the fixed charge density of the anti-reflection layer 130 is about 2.0×10¹² /cm² to 4.0×10¹² /cm², so as to prevent a reduction in the electric power resulting from a reduction in the incident area, and to efficiently reduce the moving distance of carriers moving to the front electrodes 141. As a result, the electric power of the solar cell 11 is improved.

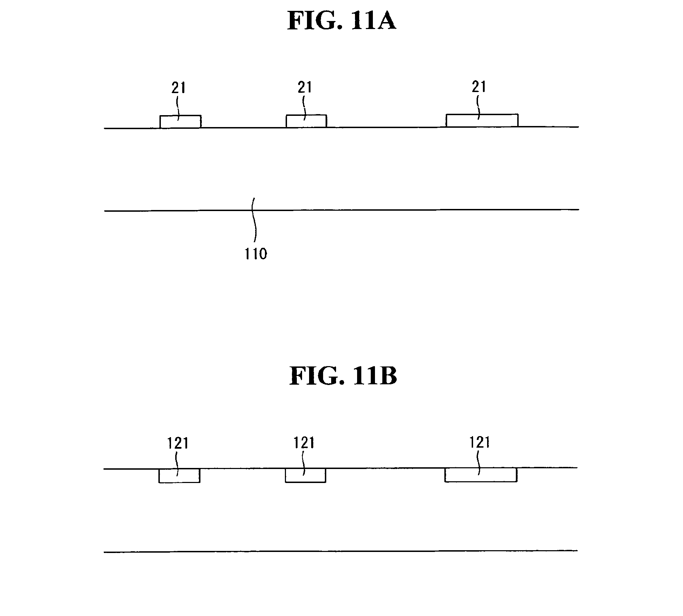

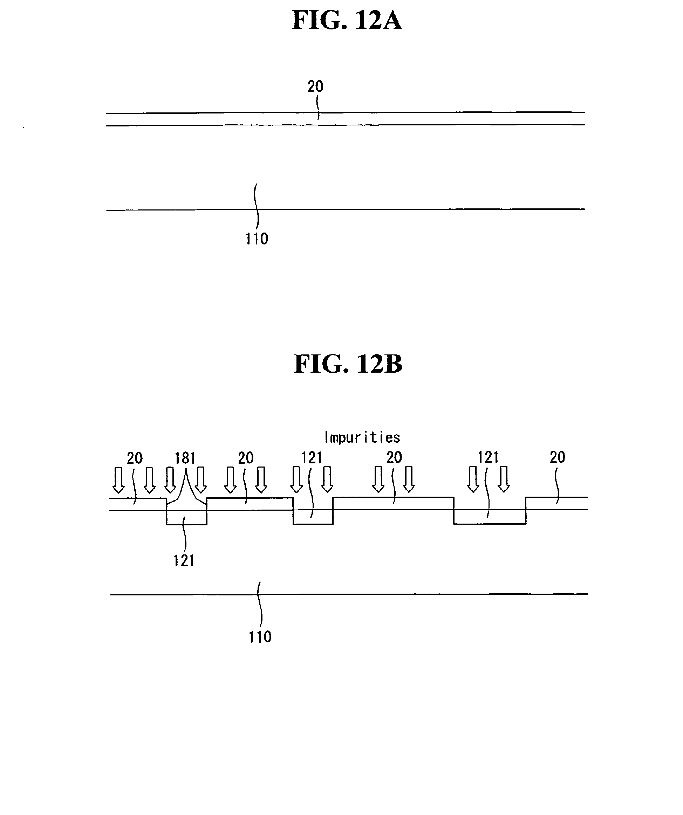

A method for manufacturing the solar cell 11 according to the embodiment of the invention is described below with reference to FIGS. 11A to 11D and FIGS. 12A and 12B.

First, as shown in FIG. 11A, a material containing impurities of a group V is partially or selectively applied to one surface (i.e., an incident surface on which light is incident) of a p-type substrate 110 and then is dried to form an impurity film 21. On the other hand, when an n-type substrate 110 is used, a material containing impurities of a group III may be used to form the impurity film 21.

The impurity film 21 may be formed by applying an ink containing impurities of a corresponding conductive type to a desired location and drying the ink. Alternatively, the impurity film 21 may be formed by selectively applying a paste containing impurities of a corresponding conductive type to a desired portion. Further, an impurity oxide layer may be formed on the surface of the substrate 110 using another film deposition method, and the impurity oxide layer may be used as the impurity film 21.

Next, as shown in FIG. 11B, a laser beam is irradiated onto the impurity film 21 to selectively or partially form an n-type ohmic contact region 121 doped with impurities of a group V at a front surface of the substrate 110. In this instance, the ohmic contact region 121 may have a sheet resistance of about 5 Ω/sq. to 45 Ω/sq. Afterwards, the impurity film 21 remaining on the front surface of the substrate 110 is removed using dilute HF (DHF) solution, etc. Hence, the ohmic contact region 121 is formed only at a corresponding portion of the front surface of the substrate 110.

Alternatively, as shown in FIGS. 12A and 12B, the ohmic contact region 121 may be formed using another method.

As shown in FIG. 12A, an anti-diffusion layer 20 formed of a material such as silicon nitride (SiNx) or silicon oxide (SiOx), etc., is formed on the front surface of the substrate 110. Next, as shown in FIG. 12B, the laser beam is irradiated onto a desired portion of the anti-diffusion layer 20 to form an opening 181 exposing a portion of the substrate 110. In this instance, a thickness of the anti-diffusion layer 20 is controlled, so that impurities are not diffused into an undesired portion of the substrate 110 through the anti-diffusion layer 120.

After forming the opening 181, as shown in FIG. 12B, n-type impurities are injected into the exposed portion of the substrate 110 through the opening using an ion implantation method or a thermal diffusion method to partially or selectively form the ohmic contact region 121 at the front surface of the substrate 110. Afterwards, the anti-diffusion layer 20 remaining on the substrate 110 and a residue such as phosphorous silicate glass (PSG) or boron silicate glass (BSG) formed on the ohmic contact region 121 are removed.

When the ohmic contact region 121 is formed using the ion implantation method, the ohmic contact region 121 is formed only at the front surface of the substrate 110. On the other hand, when the ohmic contact region 121 is formed using the thermal diffusion method, the ohmic contact region 121 may be formed at the back surface and the sides of the substrate 110 on each of which the anti-diffusion layer 20 is not formed as well as the front surface of the portion of the substrate 110 exposed through the opening 181. If necessary, before the ohmic contact region 121 is formed at the substrate 110, a texturing process may be performed on the flat front surface of the substrate 110 to form a textured surface of the substrate 110. When the substrate 110 is formed of single crystal silicon, the texturing process may be performed using a base solution such as KOH and NaOH. When the substrate 110 is formed of polycrystalline silicon, the texturing process may be performed using an acid solution such as HF and HNO₃.

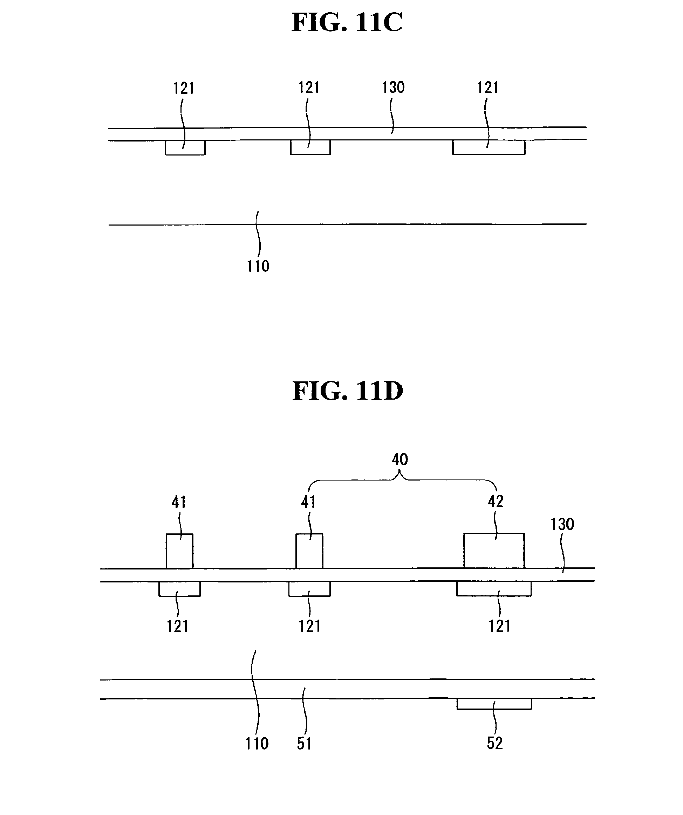

Next, as shown in FIG. 11C, after the ohmic contact region 121 is formed at the front surface of the substrate 110, an anti-reflection layer 130 is formed on the front surface of the substrate 110 using a plasma enhanced chemical vapor deposition (PECVD) method, etc. In this instance, the anti-reflection layer 130 may be formed of silicon nitride (SiNx) having a fixed charge density of about 2.0×10¹² /cm² to 4.0×10¹² /cm². The fixed charge density of the anti-reflection layer 130 may vary by adjusting a supply amount of each of silane (SiH₄) gas and ammonia (NH₃) gas used to form a silicon nitride layer.

As described above, when the p-type substrate 110 is used, the anti-reflection layer 130 may be formed of silicon nitride (SiNx) having a positive fixed charge. Alternatively, when the n-type substrate 110 is used, the anti-reflection layer 130 may be formed of aluminum oxide (Al₂O₃) having a negative fixed charge.

Next, as shown in FIG. 11D, a front electrode part paste containing silver (Ag) is printed on the anti-reflection layer 130 using a screen printing method and then is dried to form a front electrode part pattern 40. A back electrode paste containing aluminum (Al) is printed on the back surface of the substrate 110 using the screen printing method and then is dried to form a back electrode pattern 51. A back bus bar paste containing silver (Ag) is printed on the back electrode pattern 51 using the screen printing method and then is dried to form a back bus bar pattern 52.

The front electrode part pattern 40 is formed only on a portion of the substrate 110, at which the ohmic contact region 121 is formed. The front electrode part pattern 40 includes a front electrode pattern 41 and a front bus bar pattern 42. Thus, the ohmic contact region 121 formed at the front surface of the substrate 110 includes first portions, which are spaced apart from one another and extend parallel to one another in a first direction, and second portions, which are spaced apart from one another and extend parallel to one another in a second direction crossing the first direction. Thus, the first portions and second portions of the ohmic contact region 121 cross each other. The front electrode pattern 41 may be positioned on the first portions, and the front bus bar pattern 42 may be positioned on the second portions.

In the embodiment of the invention, the front electrode part pattern 40, the back electrode pattern 51, and the back bus bar pattern 52 may be dried at about 120 °C to 200 °C. A formation order of the front electrode part pattern 40 and the back electrode pattern 51 may vary.

Afterwards, a thermal process is performed on the substrate 110, on which the front electrode part pattern 40, the back electrode pattern 51, and the back bus bar pattern 52 are formed, at the temperature of about 750°C to 800 °C. Hence, a front electrode part 140 which contacts the ohmic contact region 121 and includes a plurality of front electrodes 141 and a plurality of front bus bars 142, a back electrode part 150 including a back electrode 151 connected to the substrate 110 and a plurality of back bus bars 152 connected to the back electrode 151, and a BSF region 172 positioned at the back surface of the substrate 110 contacting the back electrode 151 are formed.

More specifically, when the thermal process is performed, the front electrode part pattern 40 passes through the anti-reflection layer 130 contacting the front electrode part pattern 40 due to lead oxide (PbO), etc., contained in the front electrode part paste for forming the front electrode part pattern 40 to form the plurality of front electrodes 141 contacting the ohmic contact region 121 and the plurality of front bus bars 142 contacting the ohmic contact region 121. Hence, the front electrode part 140 is completed. Accordingly, a solar cell 11 shown in FIGS. 1 and 2 is completed.

The front electrode pattern 41 of the front electrode part pattern 40 forms the plurality of front electrodes 141, and the front bus bar pattern 42 of the front electrode part pattern 40 forms the plurality of front bus bars 142.

Further, when the thermal process is performed, the back electrode pattern 51 forms the back electrode 151, and the back bus bar pattern 52 forms the plurality of back bus bars 152. Aluminum (Al) contained in the back electrode pattern 51 is diffused into the inside of the substrate 110 to form the BSF region 172 having an impurity doping concentration higher than the substrate 110 at the back surface of the substrate 110. Hence, the back electrode 151 contacts the BSF region 172, and thus, is electrically connected to the substrate 110.

When the ohmic contact region 121 is formed at both the front surface and the back surface of the substrate 110 using the thermal diffusion method, aluminum (Al) contained in the back electrode pattern 51 is diffused into the ohmic contact region 121 positioned at the back surface of the substrate 110 and the inside of the substrate 110 passing through the ohmic contact region 121 to thereby form the BSF region 172 having the impurity doping concentration higher than the substrate 110 at the back surface of the substrate 110.

As above, the ohmic contact region 121 is partially (selectively or locally) positioned at the front surface of the substrate 110. Even if the ohmic contact region 121 is positioned or is not positioned at the back surface of the substrate 110, the ohmic contact region 121 positioned at the front surface of the substrate 110 is not electrically and physically connected to the ohmic contact region 121 positioned at the back surface of the substrate 110. Therefore, a separate edge isolation process for preventing the electrical connection between the ohmic contact region 121 positioned at the front surface of the substrate 110 and the ohmic contact region 121 positioned at the back surface of the substrate 110 is not necessary. Thus, the manufacturing time and the manufacturing cost of the solar cell 11 are reduced.

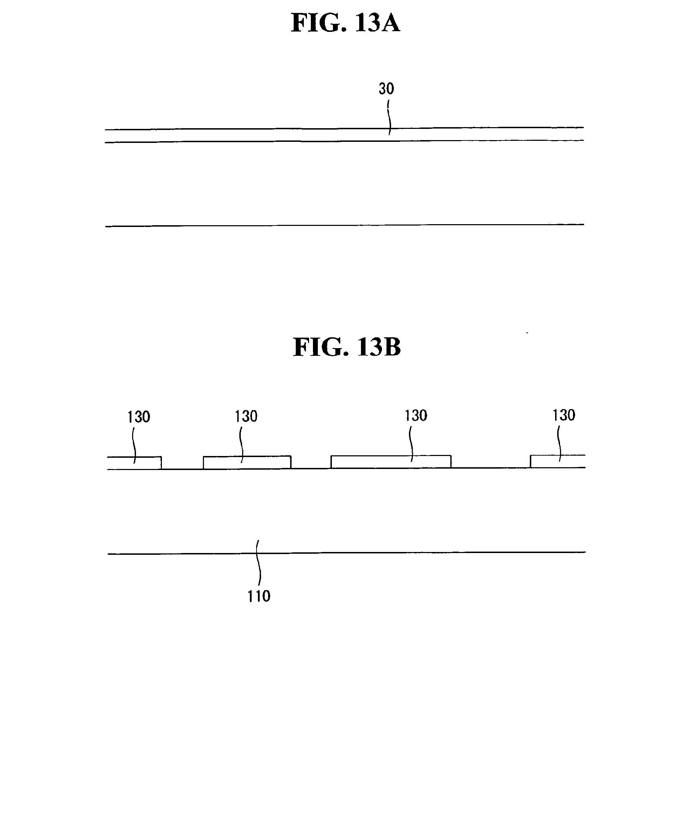

Another method for manufacturing the solar cell 11 according to the embodiment of the invention is described below with reference to FIGS. 13A to 13D.

Similar to the process illustrated in FIGS. 12A and 12B, in the process as shown in FIG. 13A, an anti-reflection part 30 is formed on a front surface of a substrate 110 using a material (for example, silicon nitride (SiNx)) having a fixed charge density of a corresponding polarity depending on a conductive type of the substrate 110. Next, as shown in FIG. 13B, a portion of the anti-reflection part 30 is removed using a laser beam, etc., to form an anti-reflection layer 130 having an opening 182 for exposing a portion of the substrate 110.

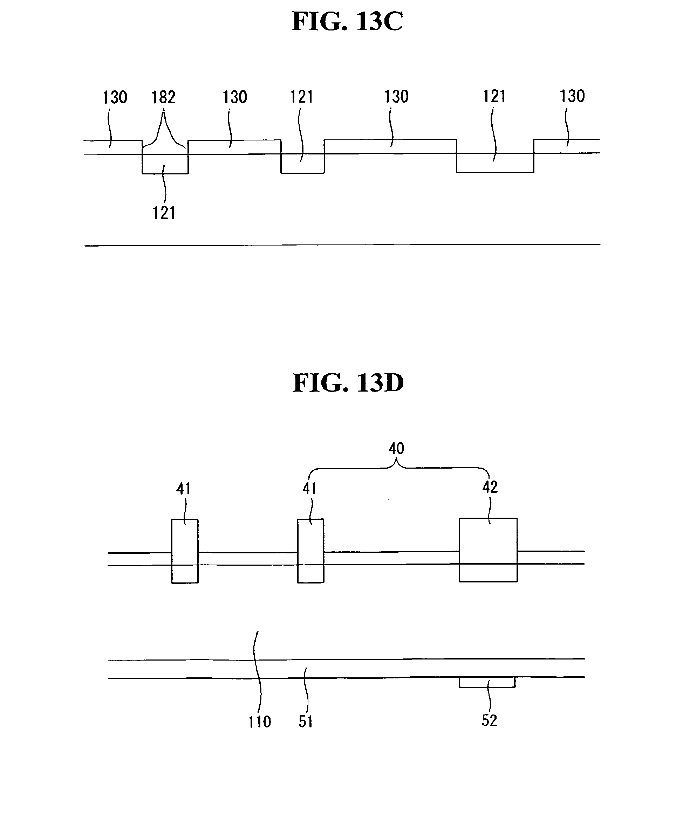

Afterwards, impurities of a corresponding conductive type are injected into the exposed portion of the substrate 110 using an ion implantation method or a thermal diffusion method to partially form an ohmic contact region 121 at the substrate 110. Next, as shown in FIG. 13C, a residue such as phosphorous silicate glass (PSG) or boron silicate glass (BSG) remaining on the anti-reflection layer 130 and the exposed portion of the substrate 110 is removed using dilute HF (DHF) solution, etc.

Although the anti-reflection layer 130 exposed to a process room is doped with impurities, an impurity doped region formed at the surface of the anti-reflection layer 130 is almost removed through a removing process of PSG or BSG. Further, changes in characteristic of the fixed charge density of the anti-reflection layer 130 resulting from the impurities injected into the anti-reflection layer 130 is not greatly generated.

Next, as shown in FIG. 13D, as described above with reference to FIG. 11D, a front electrode part pattern 40 including a front electrode pattern 41 and a front bus bar pattern 42 is selectively or partially formed on the front surface of the substrate 110, i.e., on the ohmic contact region 121 using a screen printing method. Further, a back electrode pattern 51 and a back bus bar pattern 52 are formed on the back surface of the substrate 110 using the screen printing method. Afterwards, a thermal process is performed to form a front electrode part 140, which includes a plurality of front electrodes 141 and a plurality of front bus bars 142 and is electrically and physically connected to the ohmic contact region 121, a back electrode 151, and a plurality of back bus bars 152.

When the solar cell 11 is formed through the above-described process, the anti-reflection layer 130 formed on the front surface of the substrate 110 is used as an anti-diffusion layer so as to dope impurities only on a portion of the substrate 110. Therefore, a process forming the ohmic contact region 121 at a portion of the substrate 110 is more simply performed. Hence, the manufacturing time and the manufacturing cost of the solar cell 11 are reduced.

Further, because the process for forming the front electrode part 140 is performed on the exposed portion of the anti-reflection layer 130 after the portion of the anti-reflection layer 130 is removed, the front electrode part pattern 40 does not need to pass through the anti-reflection layer 130. Hence, a temperature in the thermal process for forming the front electrode part 140 and the back electrode part 150 is low or lower. As a result, the degradation and changes in physical characteristics of the substrate 110 and the components positioned on the substrate 110 resulting from heat are reduced or prevented.

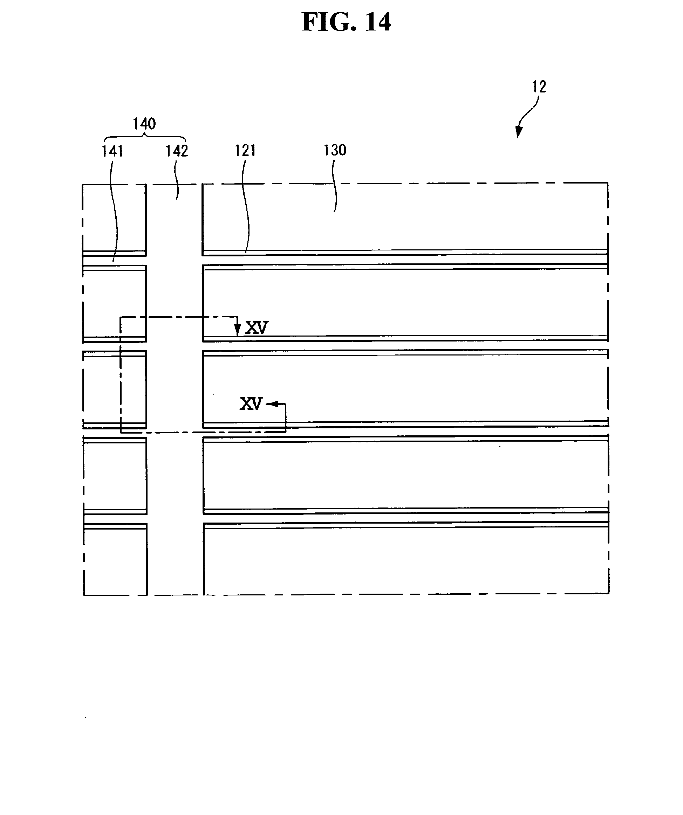

Solar cells 12 and 13 according to embodiments of the invention are described below with reference to FIGS. 14 to 17.

Structures and components identical or equivalent to those illustrated in the solar cell 11 shown in FIGS. 1 and 2 and the solar cells 12 and 13 shown in FIGS. 14 to 17 are designated by the same reference numerals, and a further description may be briefly made or may be entirely omitted.

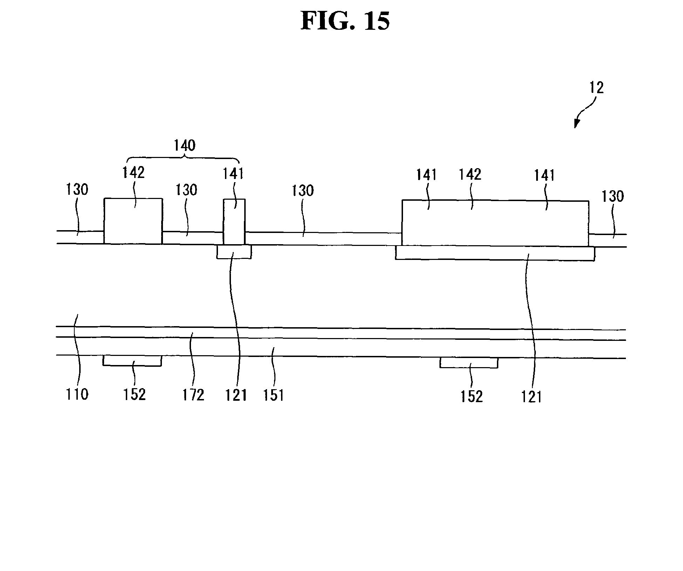

First, the solar cell 12 according to the embodiment of the invention is described with reference to FIGS. 14 and 15.

Similar to the solar cell 11 shown in FIGS. 1 and 2, the solar cell 12 shown in FIGS. 14 and 15 includes an ohmic contact region 121 partially (selectively or locally) positioned at a front surface of the substrate 110, an anti-reflection layer 130 positioned on the substrate 110, a front electrode part 140 including a plurality of front electrodes 141 and a plurality of front bus bars 142, a BSF region 172 positioned at a back surface opposite the front surface of the substrate 110, and a back electrode part 150 which is positioned on the back surface of the substrate 110 and includes a back electrode 151 and a plurality of back bus bars 152.

However, as shown in FIG. 14, a formation location of the ohmic contact region 121 is different from the solar cell 11 shown in FIGS. 1 and 2.

Namely, as shown in FIG. 14, the ohmic contact region 121 is positioned under the plurality of front electrodes 141 and is not positioned under the plurality of front bus bars 142 except at crossings of the front electrodes 141 and the front bus bars 142. Hence, the plurality of front bus bars 142 directly contact the substrate 110. Thus, the ohmic contact region 121 has the same number as the number of front electrodes 141. Similar to the plurality of front electrodes 141, the plurality of ohmic contact regions 121 are spaced apart from one another and extend parallel to one another along the front electrodes 141. Thus, the plurality of ohmic contact regions 121 are disposed in a stripe shape and are not disposed in a lattice shape unlike the ohmic contact region 121 of the solar cell 11.

As a result, a formation area of the ohmic contact regions 121 in the solar cell 12 is less than a formation area of the ohmic contact region 121 in the solar cell 11.

Each front electrode 141 has a width of about 80 µm to 120 µm, and each front bus bar 142 has a width of about 1.5 mm to 2 mm. Because each front bus bar 142 has the width much greater than the width of each front electrode 141, a contact area between the front bus bar 142 and the substrate 110 is much greater than a contact area between the front electrode 141 and the substrate 110.

Accordingly, although a separate ohmic contact region 121 for forming the ohmic contact is not formed at the contact areas between the front bus bars 142 and the substrate 110 unlike the solar cell 11 shown in FIGS. 1 and 2, the carrier transfer efficiency between the substrate 110 and the front bus bars 142 is not greatly reduced. Further, because the front bus bars 142 mainly collect carriers transferred through the front electrodes 141 unlike the front electrodes 141 collecting carriers moving to the front surface of the substrate 110, even though a contact resistance between the substrate 110 and the front bus bars 142 is not better than a contact resistance between the substrate 110 and the front electrodes 141, the front bus bars 142 does not largely affect to a collection amount of charge of the solar cell 12.

On the other hand, because the formation area of the plurality of ohmic contact regions 121, which are heavily doped regions, decreases, a loss amount of carriers inside the substrate 110 due to the impurities of the ohmic contact regions 121 decreases. Therefore, a collection amount of carriers by the front electrodes 141 increases.

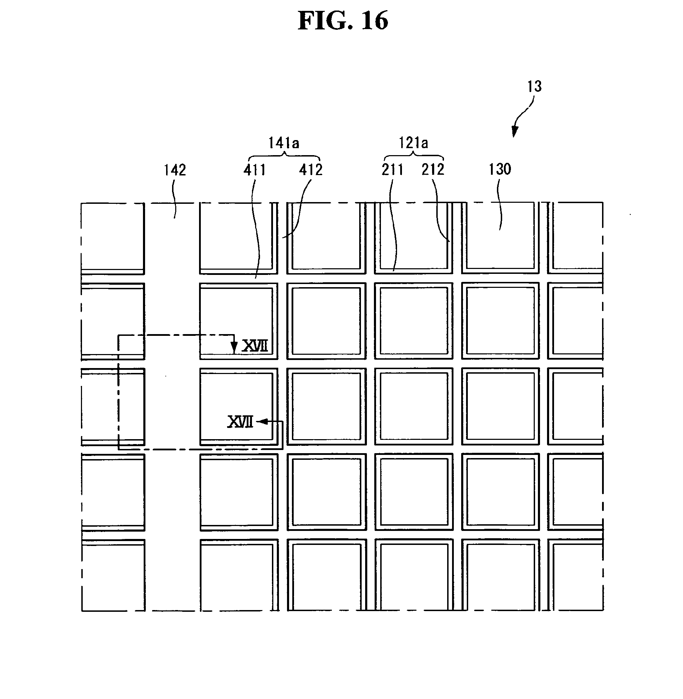

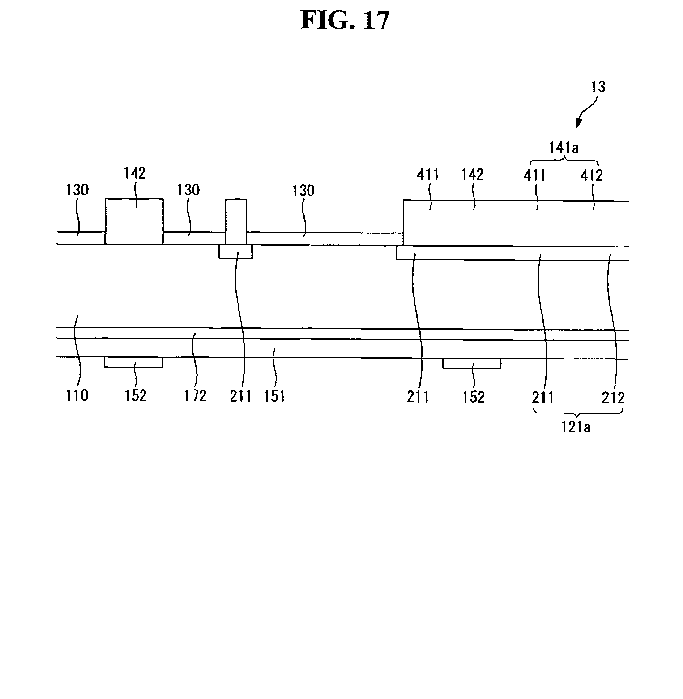

Since configuration of the solar cell 13 shown in FIGS. 16 and 17 is substantially the same as the solar cell 12 shown in FIGS. 14 and 15 except a front electrode, a further description may be briefly made or may be entirely omitted. A front electrode 141a shown in FIGS. 16 and 17 has a lattice shape. More specifically, the front electrode 141a includes a plurality of first portions 411 extending in a direction crossing the front bus bars 142 and a plurality of second portions 412 which extend in the same direction as the front bus bars 142 and do not cross the front bus bars 142. Namely, the front electrode 141a further includes the plurality of second portions 412 in comparison to the front electrodes 141 shown in FIGS. 14 and 15.

An ohmic contact region 121a is positioned under the front electrode 141a and extends along the front electrode 141a. Thus, the ohmic contact region 121a includes a plurality of first portions 211 positioned under the first portions 411 of the front electrode 141 a and a plurality of second portions 212 positioned under the second portions 412 of the front electrode 141 a.

In the solar cell 13 shown in FIGS. 16 and 17, the ohmic contact region 121a is not positioned under the front bus bars 142 except at crossings of the front electrode 141 a and the front bus bars 142. However, as described above with reference to FIGS. 1 to 3, the ohmic contact region 121a may be positioned under the front bus bars 142 if desired in a modified embodiment of the invention.

As above, because the number of formation locations of the front electrode 141a increases, a moving distance of carriers moving to the front electrode 141 a decreases and the number of moving paths of carriers moving to the front electrode 141 a increases. Hence, an amount of carriers collected by the front electrode 141 a increases. A distance between the two adjacent first portions 411 and a distance between the two adjacent second portions 412 may increase by an increase in the formation area of the front electrode 141 a. In this instance, an incident area of the solar cell 13 may increase, and thus, an amount of carriers produced in the solar cell 13 may further increase.

In the solar cell 13 shown in FIGS. 16 and 17, the ohmic contact region 121 a may be positioned under the front bus bars 142.

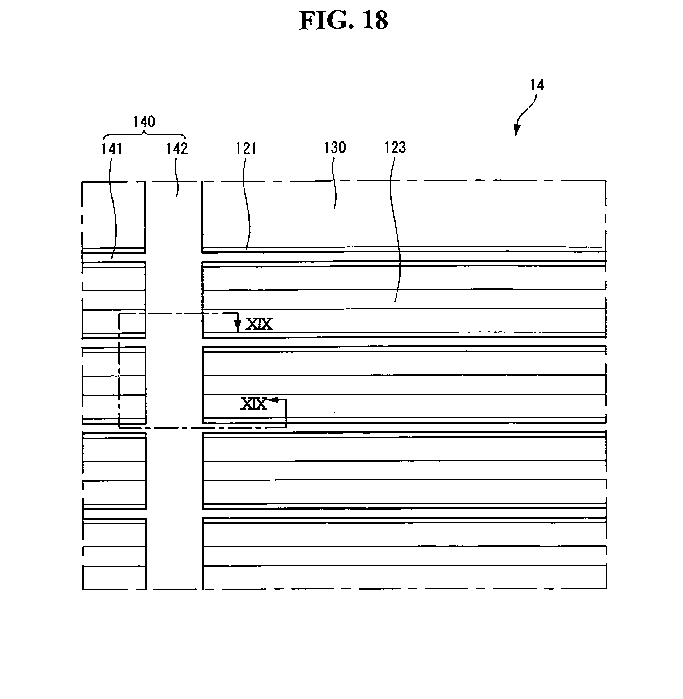

Solar cells 14 to 16 according to the embodiment of the invention are described below with reference to FIGS. 18 to 23. Structures and components identical or equivalent to those illustrated in the solar cell 11 shown in FIGS. 1 and 2 and the solar cells 14 to 16 shown in FIGS. 18 to 23 are designated by the same reference numerals, and a further description may be briefly made or may be entirely omitted.

The solar cells 14 to 16 shown in FIGS. 18 to 23 further include at least one semiconductor electrode 123 in addition to the configuration of one of the solar cells 12 and 13 shown in FIGS. 14 to 17.

The semiconductor electrode 123 shown in FIGS. 18 to 23 is an impurity doped region obtained by doping impurities of the same conductive type (i.e., a second conductive type) as an ohmic contact region 121 on a substrate 110 of a first conductive type. The semiconductor electrode 123 is simultaneously formed when the ohmic contact region 121 is formed. The semiconductor electrode 123 has the same sheet resistance as the ohmic contact region 121. For example, the semiconductor electrode 123 may have the sheet resistance of about 5 Ω/sq. to 45 Ω/sq. Further, the semiconductor electrode 123 has the same impurity doping depth (or the same impurity doping thickness) and the same impurity doping concentration as the ohmic contact region 121.

In the solar cells 14 to 16 shown in FIGS. 18 to 23, the front electrodes 141 are positioned on the ohmic contact region 121, and an anti-reflection layer 130 formed of a desired material which does not disturb a light incidence onto the substrate 110 is positioned directly on the semiconductor electrode 123 except a portion crossing at least one of the front electrode 141 and the front bus bar 142. Hence, light is incident on the semiconductor electrode 123.

In the solar cells 14 to 16 shown in FIGS. 18 to 23, impurities of the second conductive type are doped on the substrate 110 of the first conductive type to form an impurity doped region of the second conductive type having the impurity doping concentration higher than the substrate 110. In this instance, a portion of the impurity doped region forms the ohmic contact region 121, and a remaining portion of the impurity doped region forms the semiconductor electrode 123.

In general, the movement of carriers when carriers move through a relatively low sheet resistance portion of the impurity doped region of the second conductive type is easier than the movement of carriers when the carriers move through a relatively high sheet resistance portion of the impurity doped region of the second conductive type. Further, as an impurity doping concentration of the impurity doped region increases, the conductivity of the impurity doped region increases.

Accordingly, as in the embodiment of the invention, when corresponding carriers (for example, electrons) move to the front electrode 141 or the front bus bar 142, carriers positioned in the substrate 110 having the relatively high sheet resistance move to the ohmic contact region 121 or the semiconductor electrode 123, which has the sheet resistance less than the substrate 110 and is positioned close to the substrate 110. Thus, carriers moving to the semiconductor electrode 123 move along the semiconductor electrode 123 having the good conductivity. The semiconductor electrode 123 contacts at least one of the front electrode 141 and the front bus bar 142, each of which contains a metal material and has the better conductivity than the semiconductor electrode 123. Thus, when carriers moving to the semiconductor electrode 123 meet the front electrode 141 or the front bus bar 142, the carriers move to the front electrode 141 or the front bus bar 142.

As above, the carriers move to not only the front electrode 141 and the front bus bar 142 but also to the semiconductor electrode 123 adjacent to the front electrode 141 and the front bus bar 142 because of the formation of the semiconductor electrode 123. Hence, various moving directions of carriers may be obtained, and a moving distance of carriers may decrease. Further, an amount of carriers lost by impurities or a defect inside the substrate 110 decreases because of a reduction in the moving distance of carriers.

Because only the anti-reflection layer 130 is formed on the semiconductor electrode 123, a reduction in the incident area of light resulting from the semiconductor electrode 123 is not generated. Instead, as described above, an amount of carriers moving to the front electrodes 141 greatly increases without the reduction in the incident area of light because of the reduction in the moving distance of carriers and the reduction in the loss amount of carriers.

An amount of carriers moving to the front electrodes 141 increases due to the presence of the semiconductor electrode 123, and a design margin of the front electrodes 141 increases. In other words, because an amount of carriers collected by the semiconductor electrode 123 for assisting the front electrodes 141 increases, the efficiency of the solar cell is not reduced by a reduction in a collection amount of carriers resulting from an increase in a distance between the front electrodes 141.

The structure of the semiconductor electrode 123 shown in FIGS. 18 to 23 is described in detail.

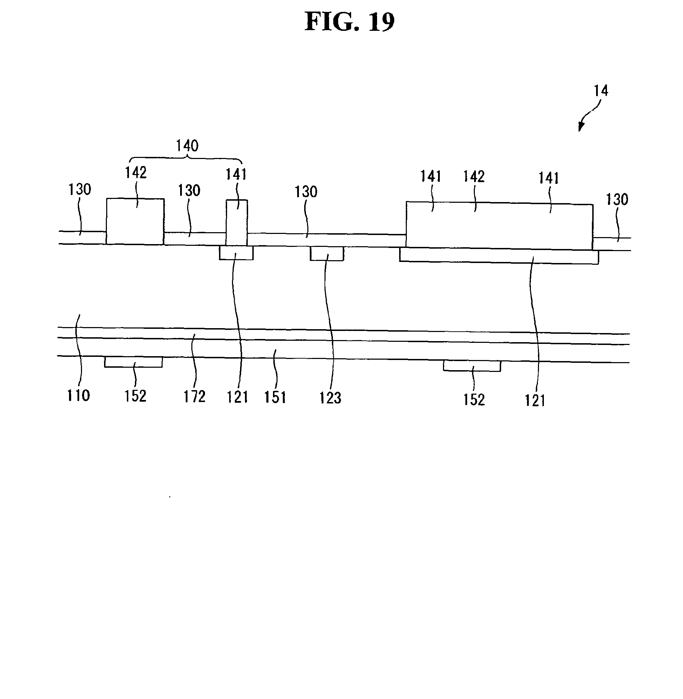

The solar cell 14 shown in FIGS. 18 and 19 further includes the plurality of semiconductor electrodes 123 in addition to the configuration of the solar cell 12 shown in FIGS. 14 and 15.

The plurality of semiconductor electrodes 123 are spaced apart from the plurality of front electrodes 141 and extend parallel to the front electrodes 141. In other words, the semiconductor electrodes 123 are separated from the front electrodes 141 and extend in the same direction as an extension direction of the front electrodes 141. Hence, the semiconductor electrodes 123 cross the plurality of front bus bars 142 and are connected to the front bus bars 142 at crossings of the semiconductor electrodes 123 and the front bus bars 142.

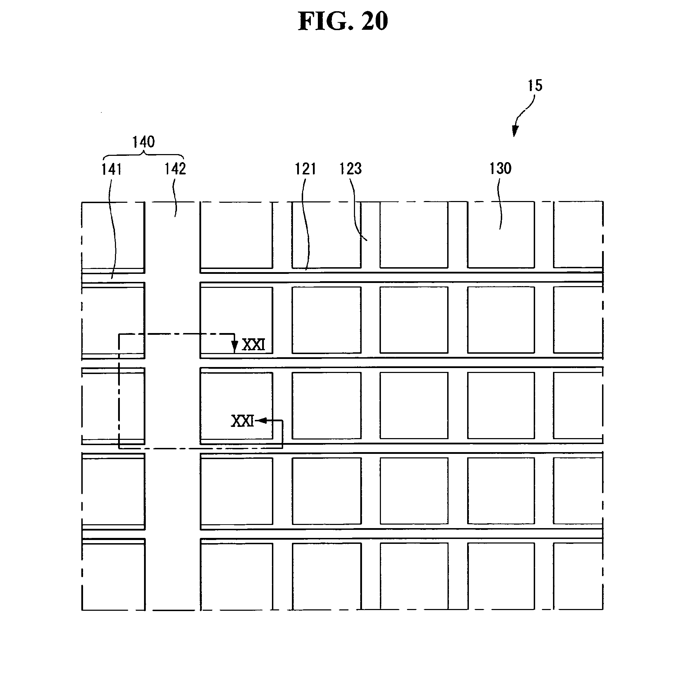

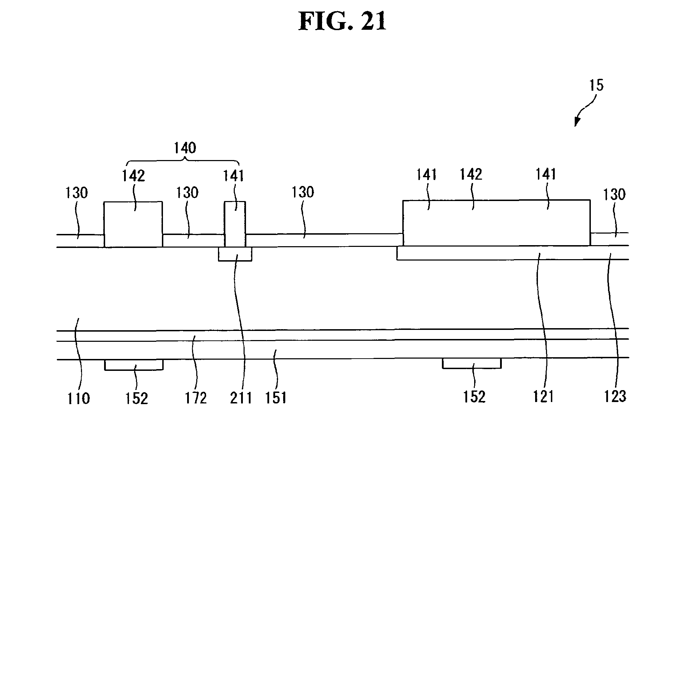

Configuration of the solar cell 15 shown in FIGS. 20 and 21 is substantially the same as the solar cell 14 shown in FIGS. 18 and 19 except an extension direction of the plurality of semiconductor electrodes 123.

In the solar cell 14 shown in FIGS. 18 and 19, the semiconductor electrodes 123 extend in the same direction as the extension direction of the front electrodes 141. On the other hand, in the solar cell 15 shown in FIGS. 20 and 21, the semiconductor electrodes 123 are spaced apart from the front bus bars 142 and extend in the same direction as an extension direction of the front bus bars 142. Thus, the semiconductor electrodes 123 shown in FIGS. 20 and 21 cross the front electrodes 141 and are connected to the front electrodes 141 at crossings of the semiconductor electrodes 123 and the front electrodes 141.

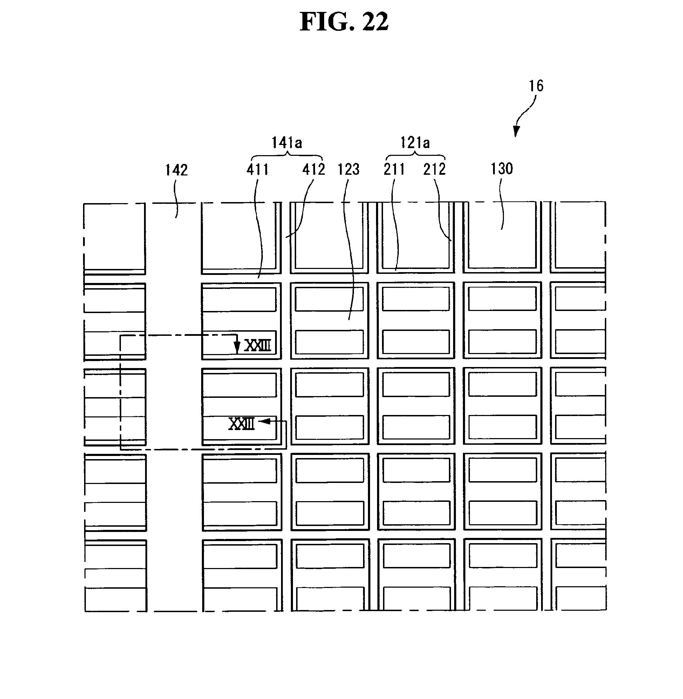

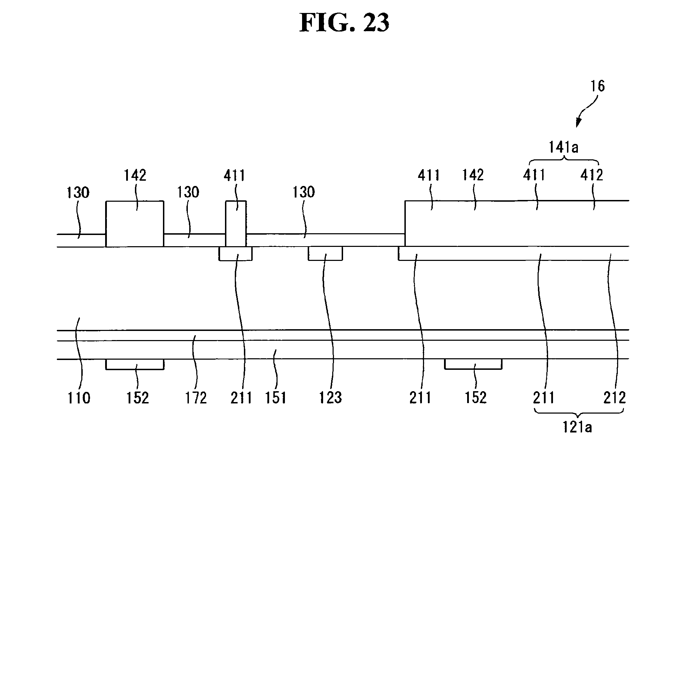

The solar cell 16 shown in FIGS. 22 and 23 further includes the plurality of semiconductor electrodes 123 in comparison to the solar cell 13 shown in FIGS. 16 and 17. The plurality of semiconductor electrodes 123 are spaced apart from the plurality of first portions 411 of the front electrode 141 a and extend parallel to the first portions 411. In the solar cells 14 to 16 shown in FIGS. 18 to 23, the ohmic contact region 121 is not positioned under the front bus bars 142 except at crossings of the front electrodes 141 (or 141a) and the front bus bars 142. However, as described above with reference to FIGS. 1 to 3, the ohmic contact region 121 may be positioned under the front bus bars 142 if desired in a modified embodiment of the invention.

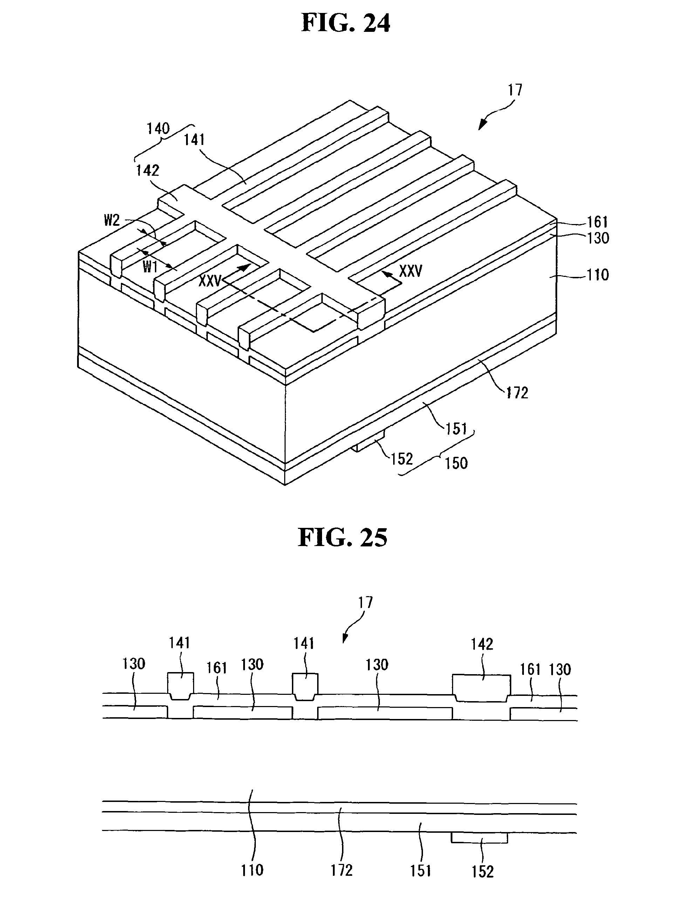

Hereinafter, a solar cell 17 according to another embodiment of the invention is described with reference to FIGS. 24 and 25.

Structures and components identical or equivalent to those illustrated in the solar cell 11 shown in FIGS. 1 and 2 and the solar cell 17 shown in FIGS. 24 and 25 are designated by the same reference numerals, and a further description may be briefly made or may be entirely omitted.

The solar cell 17 shown in FIGS. 24 and 25 has the structure similar to the solar cell 11 shown in FIGS. 1 and 2.

The solar cell 17 shown in FIGS. 24 and 25 includes an anti-reflection layer 130 which is positioned on a substrate 110 of a first conductive type and has a fixed charge density of about 2.0×10¹² /cm² to 4.0×10¹² /cm², a front electrode part 140 which is positioned on a front surface of the substrate 110 and includes a plurality of front electrodes 141 and a plurality of front bus bars 142, a back electrode part 150 which is positioned on a back surface of the substrate 110 and includes a back electrode 151 and a plurality of back bus bars 152, and a BSF region 172 which is positioned at the back surface of the substrate 110 and contacts the back electrode 151.

Unlike the solar cell 11 shown in FIGS. 1 and 2, the solar cell 17 shown in FIGS. 24 and 25 does not include the ohmic contact region inside the substrate 110 contacting the front electrode part 140. Instead, the solar cell 17 includes a subsidiary electrode 161 between the substrate 110 and the front electrode part 140. The subsidiary electrode 161 is formed of a transparent conductive material, for example, transparent conductive oxide (TCO) such as indium tin oxide (ITO), ZnO, and SnO₂. The subsidiary electrode 161 is positioned on the anti-reflection layer 130 and an exposed portion of the substrate 110, on which the anti-reflection layer 130 is not formed.

As above, the subsidiary electrode 161 formed of the transparent conductive material is formed between the substrate 110 formed of a semiconductor material such as single crystal silicon and polycrystalline silicon and the front electrode part 140 formed of the metal material, instead of the ohmic contact region for forming the ohmic contact between the substrate 110 and the front electrode part 140, thereby increasing an adhesive strength (i.e., adhesive characteristic) between the semiconductor material and the metal material. In other words, the subsidiary electrode 161 is formed as the ohmic contact region between the substrate 110 and the front electrode part 140, thereby improving the electrical conductivity between the substrate 110 and the front electrode part 140. In the embodiment of the invention, the subsidiary electrode 161 is formed on the substrate 110, instead of the ohmic contact region formed by injecting impurities into the substrate 110 so as to form the ohmic contact between the substrate 110 and the front electrode part 140. Accordingly, portions of the subsidiary electrode 161 may be formed to directly contact the substrate 110 where the subsidiary electrode 161 aligned with the front electrode part 140.

As a result, corresponding carriers (for example, electrons) moving to the anti-reflection layer 130 due to the fixed charge density of the anti-reflection layer 130 easily and smoothly move to the front electrode part 140 through the subsidiary electrode 161.

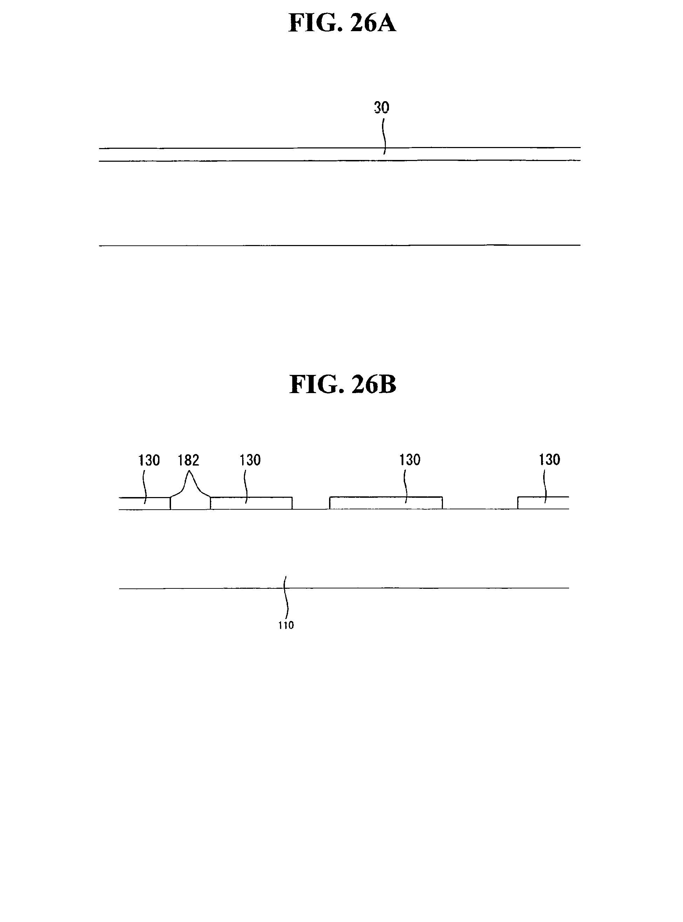

A method for manufacturing the solar cell 17 is described below with reference to FIGS. 26A to 26D.

As shown in FIG. 26A, an anti-reflection part 30 having a fixed charge density of about 2.0×10¹² /cm² to 4.0×10¹² /cm² is formed on a front surface of a substrate 110. As shown in FIG. 26B, a potion of the anti-reflection part 30 is removed using a laser, etc., to form an anti-reflection layer 130 having an opening 182 for exposing a portion of the front surface of the substrate 110.

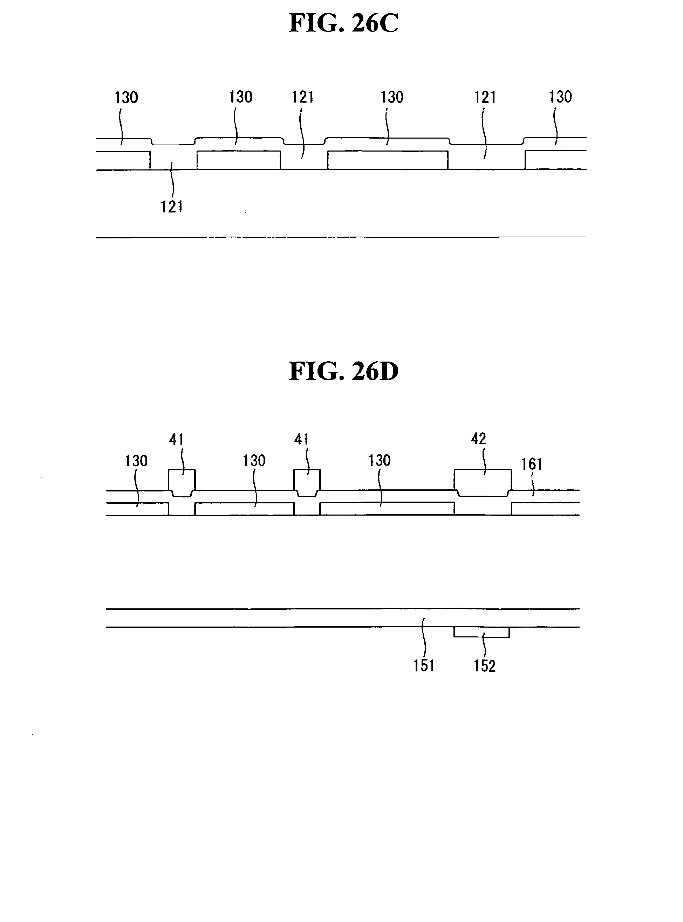

Next, as shown in FIG. 26C, a subsidiary electrode 161 formed of ITO is formed on the anti-reflection layer 130 and on an exposed portion of the substrate exposed through the opening 182 using a sputtering method, etc.

Next, as shown in FIG. 26D, as described above with reference to 11D, a front electrode part paste containing silver (Ag) is partially or locally printed on the subsidiary electrode 161 using a screen printing method and then is dried to form a front electrode part pattern 40. A back electrode paste containing aluminum (Al) is printed on a back surface of the substrate 110 using the screen printing method and then is dried to form a back electrode pattern 51. A back bus bar paste containing silver (Ag) is printed on the back electrode pattern 51 using the screen printing method and then is dried to form a back bus bar pattern 52.

The front electrode part pattern 40 includes a front electrode pattern 41 and a front bus bar pattern 42 and is positioned on the subsidiary electrode 161 directly contacting the substrate 110.

Afterwards, a thermal process is performed on the substrate 110 to form a front electrode part 140 which is electrically and physically connected to the subsidiary electrode 161 and includes a plurality of front electrodes 141 and a plurality of front bus bars 142, a back electrode part 150 including a back electrode 151 electrically and physically connected to the substrate 110 and a plurality of back bus bars 152 electrically and physically connected to the back electrode 151, and a BSF region 172 positioned at the back surface of the substrate 110.

When the solar cell 17 is formed through the above-described process, a process for diffusing impurities into the substrate 110 is not necessary. Therefore, the manufacturing process of the solar cell 17 is simple. Further, because the thermal process for diffusing the impurities is omitted, the degradation of the substrate 110 is prevented or reduced.

Furthermore, because the process for forming the front electrode part 140 is performed directly on the exposed portion of the substrate 110 after the portion of the anti-reflection layer 130 is removed, the front electrode part 140 and the back electrode part 150 are formed at a temperature lower than a temperature in the thermal process performed when the front electrode part pattern 40 passes through the anti-reflection layer 130. Hence, the degradation and changes in physical characteristics of the substrate 110 and the components positioned on the substrate 110 resulting from heat are reduced or prevented.

The embodiment of the invention mainly described the p-type substrate 110 as an example, but may use the n-type substrate 110. In this instance, the anti-reflection layer 130 may have a negative fixed charge density of about 2.0× 10¹² /cm² to 4.0× 10¹² /cm².

## Claims

1. A solar cell comprising:
a semiconductor substrate containing first impurities of a first conductive type;
an anti-reflection layer positioned on the semiconductor substrate, the anti-refection layer having a fixed charge of the first conductive type;
an ohmic contact region in which second impurities of a second conductive type different from the first conductive type of the first impurities of the semiconductor substrate are selectively positioned at the semiconductor substrate;
a plurality of first electrodes which are positioned on the ohmic contact region and are connected to the ohmic contact region; and
a second electrode connected to the semiconductor substrate.

2. The solar cell of claim 1, further comprising a semiconductor electrode positioned in a direction crossing or parallel to the plurality of first electrodes.

3. The solar cell of claim 1 or 2, wherein the plurality of first electrodes are disposed in a lattice shape.

4. The solar cell of any one preceding claim, wherein the anti-reflection layer includes a first layer positioned directly on the semiconductor substrate and a second layer positioned on the first layer, and
wherein the first layer has the fixed charge, and the second layer does not have the fixed charge.

5. The solar cell of any one preceding claim, wherein the ohmic contact region is further positioned on the anti-reflection layer.

6. The solar cell of any one preceding claim, wherein the anti-reflection layer has a fixed charge density of about 2.0×10¹² /cm² to 4.0×10¹² /cm².

7. A method for manufacturing a solar cell, the method comprising:
selectively forming an ohmic contact region at a first portion of a semiconductor substrate;
forming an anti-reflection layer having a fixed charge density directly on a second portion of the semiconductor substrate, at which the ohmic contact region is not formed; and
forming a plurality of first electrodes connected to the ohmic contact region and a second electrode connected to the semiconductor substrate.

8. The method of claim 7, wherein when the semiconductor substrate is of a p-type, the anti-reflection layer has a positive fixed charge density, and when the semiconductor substrate is of an n-type, the anti-reflection layer has a negative fixed charge density.

9. The method of claim 7 or 8, wherein the forming of the ohmic contact region includes:
selectively forming an impurity film containing impurities of a second conductive type opposite a first conductive type at the first portion of the semiconductor substrate; and
applying heat to the impurity film and doping the impurities of the second conductive type on the first portion of the semiconductor substrate to form the ohmic contact region.

10. The method of any one of claims 7 to 9, wherein the forming of the ohmic contact region includes:
forming an anti-diffusion layer on the first portion of the semiconductor substrate;
removing a portion of the anti-diffusion layer to form an opening partially exposing the first portion of the semiconductor substrate in the anti-diffusion layer;
injecting impurities of a second conductive type opposite a first conductive type into the first portion of the semiconductor substrate exposed through the opening to form the ohmic contact region; and
removing the impurities remaining on the semiconductor substrate.

11. The method of claim 9 or 10, wherein the forming of the anti-reflection layer, the plurality of first electrodes, and the second electrode includes:
forming an anti-reflection part on one surface of the semiconductor substrate;
forming a first electrode pattern on the anti-reflection part;
forming a second electrode pattern on the semiconductor substrate; and
performing a thermal process on the semiconductor substrate having the first electrode pattern and the second electrode pattern,
wherein the first electrode pattern is positioned on the ohmic contact region,
wherein the first electrode pattern passes through the anti-reflection part and is connected to the ohmic contact region to form the plurality of first electrodes connected to the ohmic contact region, and the second electrode pattern forms the second electrode connected to the semiconductor substrate through the thermal process of the semiconductor substrate, and
wherein a portion of the anti-reflection part, through which the first electrode pattern does not pass, forms the anti-reflection layer.

12. The method of any of claims 7 to 11, wherein the forming of the ohmic contact region and the anti-reflection layer includes:
forming an anti-reflection part on one surface of the semiconductor substrate;
removing a portion of the anti-reflection part and forming an opening partially exposing the first portion of the semiconductor substrate in the anti-reflection part to form the anti-reflection layer; and
injecting impurities of a second conductive type opposite a first conductive type into the first portion of the semiconductor substrate exposed through the opening to form the ohmic contact region.

13. The method of claim 12, wherein the forming of the plurality of first electrodes and the second electrode includes:
forming a first electrode pattern directly on the ohmic contact region exposed through the opening;
forming a second electrode pattern on the semiconductor substrate; and
performing a thermal process on the semiconductor substrate having the first electrode pattern and the second electrode pattern,
wherein the first electrode pattern is connected to the ohmic contact region and the second electrode pattern is connected to the semiconductor substrate through the thermal process of the semiconductor substrate.

14. The method of any one of claims 7 to 13, wherein the ohmic contact region is formed of transparent conductive oxide.

15. The method of claims 14, wherein the forming of the ohmic contact region and the anti-reflection layer includes:
forming an anti-reflection part on one surface of the semiconductor substrate;
removing a portion of the anti-reflection part and forming an opening partially exposing the first portion of the semiconductor substrate in the anti-reflection part to form the anti-reflection layer; and
forming the transparent conductive oxide on the first portion of the semiconductor substrate exposed through the opening and on the anti-reflection layer to form the ohmic contact region
wherein preferentially the forming of the plurality of first electrodes and the second electrode includes:
forming a first electrode pattern on the ohmic contact region formed in the opening;
forming a second electrode pattern on the semiconductor substrate; and
performing a thermal process on the semiconductor substrate having the first electrode pattern and the second electrode pattern,
wherein the first electrode pattern is connected to the ohmic contact region and the second electrode pattern is connected to the second portion of the semiconductor substrate through the thermal process of the semiconductor substrate.
